# EUROPEAN PATENT SPECIFICATION

(11) **EP 4 495 442 B1**
(45) Date of publication and mention of the grant of the patent: **30.09.2026**
(21) Application number: 22933179.8
(22) Date of filing: 23.12.2022
(51) Int. Cl.: G06F 1/16, H04M 1/02, G09F 9/30, F16C 11/04, F16C 11/12, F16C 11/10

(54) **FOLDING DEVICE, FOLDING HOUSING AND ELECTRONIC DEVICE**
KLAPPVORRICHTUNG, KLAPPGEHÄUSE UND ELEKTRONISCHE VORRICHTUNG
DISPOSITIF DE PLIAGE, BOÎTIER DE PLIAGE ET DISPOSITIF ÉLECTRONIQUE

(30) Priority: 24.03.2022 CN 202210297159
(43) Date of publication of application: 22.01.2025
(60) Divisional application: 26200249.6
(73) Proprietor: GUANGDONG OPPO MOBILE TELECOMMUNICATIONS CORP., LTD., Dongguan, Guangdong 523860 (CN)
(72) Inventor: ZHAN, Xuechao, Dongguan, Guangdong 523860 (CN); CHENG, Gong, Dongguan, Guangdong 523860 (CN); XU, Xinghe, Dongguan, Guangdong 523860 (CN)
(74) Representative: Novagraaf Technologies
(86) International application number: PCT/CN2022/141327
(87) International publication number: WO 2023/179131

(56) References cited:
- EP-B1- 4 072 110
- WO-A1-2021/129882
- CN-A- 111 816 067
- CN-A- 113 719 523
- CN-A- 114 135 567
- CN-U- 209 654 417

## Description

### TECHNICAL FIELD

The present disclosure relates to the field of folding of flexible members, in particular, to a folding device that supports a flexible member, a folding housing including the folding device, and an electronic device including the folding housing.

### BACKGROUND

With the development of display devices, bendable flexible display screens have emerged. At present, the bendable region of an existing bendable flexible display screen is generally supported and folded by a support assembly of a folding device. The support assembly includes a middle support member located in the middle and two side support members arranged on two opposite sides of the middle support member. Each of the two side support members is able to be folded or flattened with respect to the middle support member to drive the bendable region of the bendable flexible display screen to be folded or flattened.

However, the existing side support member generally includes a support plate and a plurality of connecting members. Each connecting member is usually riveted or screwed to the support plate. The support member of this kind not only includes many components, making the manufacturing process complex and the assembling process cumbersome, but also results in high production costs.

The PCT international application No. WO 2021/129882 A1 discloses an electronic device including a screen and a housing apparatus configured to bear the screen. The housing apparatus can automatically perform avoidance in a folding process to form screen accommodation space. A folding action performed by the housing apparatus on the screen is stable, and has small squeezing force. This helps reduce a risk that the screen is damaged due to excessive squeezing by the housing apparatus, so that reliability of the screen and the electronic device is high, and a service life of the screen and the electronic device is long.

### SUMMARY

The present disclosure provides a folding device with a simple production process and a low production cost, a folding housing including the folding device, and an electronic device including the folding housing.

In some embodiments of the present disclosure, a folding device is provided. The folding device includes a support assembly, the support assembly includes a side support member on each of two opposite sides of the folding device. The side support member includes a side support plate and a plurality of inserts, and each of the plurality of inserts is embedded in a back surface of the side support plate.

The folding device further includes a rotating assembly. The rotating assembly includes a rotating member on each of two opposite sides of the folding device and a connecting member on each of two opposite sides of the folding device. The rotating member is rotatably connected to the connecting member, and at least one of the plurality of inserts on the side support member is rotatably connected to the connecting member.

The folding device further includes a linkage assembly. The linkage assembly includes a linkage member on each of two opposite sides of the folding device. The linkage member is slidably connected to the connecting member, and at least another one of the plurality of inserts on the side support member is slidably and rotatably connected to the linkage member.

The connecting member is rotatable to drive the rotating member and the linkage member to rotate, and rotations of the rotating member and the linkage member are able to drive the side support member to move, such that the two side support members on the two opposite sides of the folding device are configured to be synchronously folded or synchronously unfolded with respect to each other. The plurality of inserts of the side support plate include a rotating block and a limiting block, the rotating block includes a rotating portion and a support portion arranged on the rotating portion, and the limiting block includes a limiting portion and a support portion arranged on a front surface of the limiting portion. Each of the rotating block and the limiting block includes a connecting portion, the connecting portion protrudes from a side of the support portion away from the rotating portion or a side of the support portion away from the limiting portion, and the connecting portion is embedded in the side support plate.

In some embodiments of the present disclosure, a folding housing is further provided. The folding housing includes two frames and the folding device as described previously. The folding device is arranged between the two frames. Each of the two frames is connected to the connecting member on a corresponding one of the two opposite sides of the folding device.

In some embodiments of the present disclosure, an electronic device is further provided. The electronic device includes a flexible member and the folding housing as described previously. The flexible member is arranged on the folding housing.

### BRIEF DESCRIPTION OF THE DRAWINGS

In order to more clearly illustrate technical solutions of embodiments of the present disclosure, a brief introduction will be made below to the drawings required to be used in the embodiments. Evidently, the drawings in the following description are only some embodiments of the present disclosure. Those skilled in the art may further obtain other drawings without any creative work according to these drawings.
FIG. 1 is a schematic perspective structural view of an electronic device according to some embodiments of the present disclosure.
FIG. 2 is a schematic exploded perspective view illustrating a folding housing and a flexible member of the electronic device shown in FIG. 1.
FIG. 3 is a schematic exploded perspective structural view of the folding housing shown in FIG. 2.
FIG. 4 is a schematic perspective structural view of a folding device shown in FIG. 3.
FIG. 5 is another schematic perspective structural view of the folding device shown in FIG. 4, when viewed from another viewing angle.
FIG. 6 is a schematic exploded perspective structural view of the folding device shown in FIG. 4.
FIG. 7 is another schematic exploded perspective structural view of the folding device shown in FIG. 5, when viewed from another viewing angle.
FIG. 8 is a schematic perspective structural view of a side support member of the folding device shown in FIG. 7.
FIG. 9 is another schematic perspective structural view of the side support member shown in FIG. 8, when viewed from another viewing angle.
FIG. 10 is another schematic exploded perspective structural view of the side support member shown in FIG. 8, when viewed from another viewing angle.
FIG. 11 is a partial cross-sectional view of the side support member shown in FIG. 8.
FIG. 12 is a schematic exploded view of the side support member shown in FIG. 11.
FIG. 13 is a schematic perspective structural view of a rotating shaft mechanism shown in FIG. 6.
FIG. 14 is another schematic perspective structural view of a rotating shaft mechanism shown in FIG. 6, when viewed from another viewing angle.
FIG. 15 is a schematic exploded perspective structural view of a rotating assembly and a folding-assisting assembly of the rotating shaft mechanism shown in FIG. 13.
FIG. 16 is a schematic exploded perspective structural view of a rotating assembly and a folding-assisting assembly of the rotating shaft mechanism shown in FIG. 14.
FIG. 17 is a schematic exploded perspective structural view of the rotating assembly shown in FIG. 14.
FIG. 18 is another schematic perspective structural view of the rotating assembly shown in FIG. 17.
FIG. 19 is a schematic exploded perspective structural view of folding-assisting assembly shown in FIG. 15.
FIG. 20 is a schematic exploded perspective structural view of the folding-assisting assembly shown in FIG. 16.
FIG. 21 is a schematic structural view illustrating an end surface of the folding device shown in FIG. 4.
FIGS. 22-26 are cross-sectional views of different parts of the folding device shown in FIG. 4.
FIG. 27 is a schematic perspective structural view of the electronic device shown in FIG. 1, and the electronic device is in a folded state.
FIG. 28 is a side view of the electronic device shown in FIG. 27.

### DETAILED DESCRIPTION

A clear and complete description of technical solutions of embodiments of the present disclosure will be given below in conjunction with the accompanying drawings in the embodiments of the present disclosure. Apparently, the embodiments described below are merely a part of the embodiments of the present disclosure, rather than all of the embodiments.

**In** addition, the following embodiments are illustrated with reference to the attached drawings, and are configured to illustrate specific embodiments that can be implemented in the present disclosure. The directional terms mentioned in the present disclosure, such as "up", "down", "front", "back", "left", "right", "inside", "outside", "side", etc., are only referring to the direction of the attached drawings. Therefore, the directional terms are employed for explaining and understanding the embodiments of present disclosure, rather than indicating or implying that the apparatus or element referred to must have a specific orientation, be constructed and operated in a specific orientation, and cannot be understood as restrictions on the embodiments of present disclosure. The term "natural state" means that the apparatus or element is in a state free from an external force, such as a pulling force or a pressing force.

In the embodiments of present disclosure, unless otherwise specified or limited, terms "mount/mounted", "connect/connected", "couple/coupled", "dispose/disposed on", and the like are used in a broad sense, may include, for example, fixed connections, detachable connections, or integral connections, may also include mechanical connections, may also include direct connections or indirect connections via intervening structures, and may also include inner communications between two elements, as can be understood by those skilled in the art depending on specific contexts.

In some embodiments of the present disclosure, a folding device is provided. The folding device includes a support assembly, the support assembly includes a side support member on each of two opposite sides of the folding device. The side support member includes a side support plate and a plurality of inserts.

The folding device further includes a rotating assembly. The rotating assembly includes a rotating member on each of two opposite sides of the folding device and a connecting member on each of two opposite sides of the folding device. The rotating member is rotatably connected to the connecting member, and at least one of the plurality of inserts on the side support member is rotatably connected to the connecting member.

The folding device further includes a linkage assembly. The linkage assembly includes a linkage member on each of two opposite sides of the folding device. The linkage member is slidably connected to the connecting member, and at least another one of the plurality of inserts on the side support member is slidably and rotatably connected to the linkage member.

The connecting member is rotatable to drive the rotating member and the linkage member to rotate, and rotations of the rotating member and the linkage member are able to drive the side support member to move, such that the two side support members on the two opposite sides of the folding device are configured to be synchronously folded or synchronously unfolded with respect to each other.

Each of the plurality of inserts is embedded in a back surface of the side support plate.

The plurality of inserts of the side support plate include a rotating block and a limiting block, the rotating block includes a rotating portion and a support portion arranged on the rotating portion, and the limiting block includes a limiting portion and a support portion arranged on a front surface of the limiting portion.

Each of the rotating block and the limiting block includes a connecting portion, the connecting portion protrudes from a side of the support portion away from the rotating portion or a side of the support portion away from the limiting portion, and the connecting portion is embedded in the side support plate.

In some embodiments, the side support plate and the plurality of inserts are integrally moulded.

In some embodiments, the side support plate is made of a plastic material, the plurality of inserts and the side support plate are made of different materials, and the hardness of each of the plurality of inserts is greater than or equal to that of the side support plate.

In some embodiments, the connecting portion defines one or more positioning recesses, and the side support plate includes one or more flanges facing the one or more positioning recesses; or the connecting portion includes one or more flanges, and the side support plate defines one or more positioning recesses facing the one or more flanges.

In some embodiments, the one or more flanges are continuously or intermittently arranged on a plane substantially parallel to the back surface of the side support plate, and the one or more positioning recesses are continuously or intermittently arranged on a plane substantially parallel to the back surface of the side support plate.

In some embodiments, the rotating block and the limiting block are embedded in the side support plate, the rotating block is rotatably connected to the connecting member, and the limiting block is mated with the linkage member through an engagement between a sliding-limiting groove and a sliding-guiding portion.

In some embodiments, the limiting block defines the sliding-limiting groove, and the sliding-guiding portion is arranged in the linkage member; or the sliding-guiding portion is arranged in the limiting block, and the linkage member defines the sliding-limiting groove. The sliding-limiting groove extends obliquely in a direction away from the side support plate. The sliding-limiting groove includes a first limiting section and a second limiting section, the first limiting section and the second limiting section are located at opposite ends of the sliding-limiting groove, and the second limiting section is disposed farther away from the side support plate than the first limiting section. **In** response to the two side support members being in a fully folded state, the sliding-guiding portion is positioned at the first limiting section; and in response to the two side support members being in a flattened state, the sliding-guiding portion is positioned at the second limiting section.

In some embodiments, the folding device includes a limiting assembly. The limiting assembly includes a pushing member arranged on the linkage member, an abutting member, and an elastic member, the elastic member is configured to provide a pre-elastic force that enables the abutting member and the pushing member to abut against each other. The pushing member includes a first cam, the abutting member includes a second cam, the elastic member is configured to elastically push against the abutting member to enable the first cam and the second cam to rotatably abut against each other, the pushing member is rotatable with respect to the abutting member, the elastic member is elastically deformed by being squeezed by the abutting member, and the linkage member is maintained at a position by a friction resistance between the pushing member and the abutting member.

In some embodiments of the present disclosure, a folding housing is further provided. The folding housing includes two frames and a folding device arranged between the two frames. Each of the two frames is connected to the connecting member on a corresponding one of the two opposite sides of the folding device. The folding device includes a support assembly, the support assembly includes a side support member on each of two opposite sides of the folding device. The side support member includes a side support plate and a plurality of inserts. The folding device further includes a rotating assembly. The rotating assembly includes a rotating member on each of two opposite sides of the folding device and a connecting member on each of two opposite sides of the folding device. The rotating member is rotatably connected to the connecting member, and at least one of the plurality of inserts on the side support member is rotatably connected to the connecting member. The folding device further includes a linkage assembly. The linkage assembly includes a linkage member on each of two opposite sides of the folding device. The linkage member is slidably connected to the connecting member, and at least another one of the plurality of inserts on the side support member is slidably and rotatably connected to the linkage member. The connecting member is rotatable to drive the rotating member and the linkage member to rotate, and rotations of the rotating member and the linkage member are able to drive the side support member to move, such that the two side support members on the two opposite sides of the folding device are configured to be synchronously folded or synchronously unfolded with respect to each other. Each of the plurality of inserts is embedded in a back surface of the side support plate. The plurality of inserts of the side support plate include a rotating block and a limiting block, the rotating block includes a rotating portion and a support portion arranged on the rotating portion, and the limiting block includes a limiting portion and a support portion arranged on a front surface of the limiting portion. Each of the rotating block and the limiting block includes a connecting portion, the connecting portion protrudes from a side of the support portion away from the rotating portion or a side of the support portion away from the limiting portion, and the connecting portion is embedded in the side support plate.

In some embodiments, the side support plate and the plurality of inserts are integrally moulded.

In some embodiments, the side support plate is made of a plastic material, the plurality of inserts and the side support plate are made of different materials, and the hardness of each of the plurality of inserts is greater than or equal to that of the side support plate.

In some embodiments, the connecting portion defines one or more positioning recesses, and the side support plate includes one or more flanges facing the one or more positioning recesses; or the connecting portion includes one or more flanges, and the side support plate defines one or more positioning recesses facing the one or more flanges.

In some embodiments, the one or more flanges are continuously or intermittently arranged on a plane substantially parallel to the back surface of the side support plate, and the one or more positioning recesses are continuously or intermittently arranged on a plane substantially parallel to the back surface of the side support plate.

In some embodiments, the rotating block and the limiting block are embedded in the side support plate, the rotating block is rotatably connected to the connecting member, and the limiting block is mated with the linkage member through an engagement between a sliding-limiting groove and a sliding-guiding portion.

In some embodiments, the limiting block defines the sliding-limiting groove, and the sliding-guiding portion is arranged in the linkage member; or the sliding-guiding portion is arranged in the limiting block, and the linkage member defines the sliding-limiting groove. The sliding-limiting groove extends obliquely in a direction away from the side support plate. The sliding-limiting groove includes a first limiting section and a second limiting section, the first limiting section and the second limiting section are located at opposite ends of the sliding-limiting groove, and the second limiting section is disposed farther away from the side support plate than the first limiting section. **In** response to the two side support members being in a fully folded state, the sliding-guiding portion is positioned at the first limiting section; and in response to the two side support members being in a flattened state, the sliding-guiding portion is positioned at the second limiting section.

In some embodiments, the folding device includes a limiting assembly. The limiting assembly includes a pushing member arranged on the linkage member, an abutting member, and an elastic member, the elastic member is configured to provide a pre-elastic force that enables the abutting member and the pushing member to abut against each other. The pushing member includes a first cam, the abutting member includes a second cam, the elastic member is configured to elastically push against the abutting member to enable the first cam and the second cam to rotatably abut against each other, the pushing member is rotatable with respect to the abutting member, the elastic member is elastically deformed by being squeezed by the abutting member, and the linkage member is maintained at a position by a friction resistance between the pushing member and the abutting member.

In some embodiments of the present disclosure, an electronic device is further provided. The electronic device includes a flexible member and a folding housing. The flexible member is arranged on the folding housing. The folding housing includes two frames and a folding device arranged between the two frames. Each of the two frames is connected to the connecting member on a corresponding one of the two opposite sides of the folding device. The folding device includes a support assembly, the support assembly includes a side support member on each of two opposite sides of the folding device. The side support member includes a side support plate and a plurality of inserts. The folding device further includes a rotating assembly. The rotating assembly includes a rotating member on each of two opposite sides of the folding device and a connecting member on each of two opposite sides of the folding device. The rotating member is rotatably connected to the connecting member, and at least one of the plurality of inserts on the side support member is rotatably connected to the connecting member. The folding device further includes a linkage assembly. The linkage assembly includes a linkage member on each of two opposite sides of the folding device. The linkage member is slidably connected to the connecting member, and at least another one of the plurality of inserts on the side support member is slidably and rotatably connected to the linkage member. The connecting member is rotatable to drive the rotating member and the linkage member to rotate, and rotations of the rotating member and the linkage member are able to drive the side support member to move, such that the two side support members on the two opposite sides of the folding device are configured to be synchronously folded or synchronously unfolded with respect to each other. Each of the plurality of inserts is embedded in a back surface of the side support plate. The plurality of inserts of the side support plate include a rotating block and a limiting block, the rotating block includes a rotating portion and a support portion arranged on the rotating portion, and the limiting block includes a limiting portion and a support portion arranged on a front surface of the limiting portion. Each of the rotating block and the limiting block includes a connecting portion, the connecting portion protrudes from a side of the support portion away from the rotating portion or a side of the support portion away from the limiting portion, and the connecting portion is embedded in the side support plate.

In some embodiments, the side support plate is made of a plastic material,, the plurality of inserts and the side support plate are made of different materials, and the hardness of each of the plurality of inserts is greater than or equal to that of the side support plate.

In some embodiments, the connecting portion defines one or more positioning recesses, and the side support plate includes one or more flanges facing the one or more positioning recesses; or the connecting portion includes one or more flanges, and the side support plate defines one or more positioning recesses facing the one or more flanges.

In some embodiments, the rotating block and the limiting block are embedded in the side support plate, the rotating block is rotatably connected to the connecting member, and the limiting block is mated with the linkage member through an engagement between a sliding-limiting groove and a sliding-guiding portion.

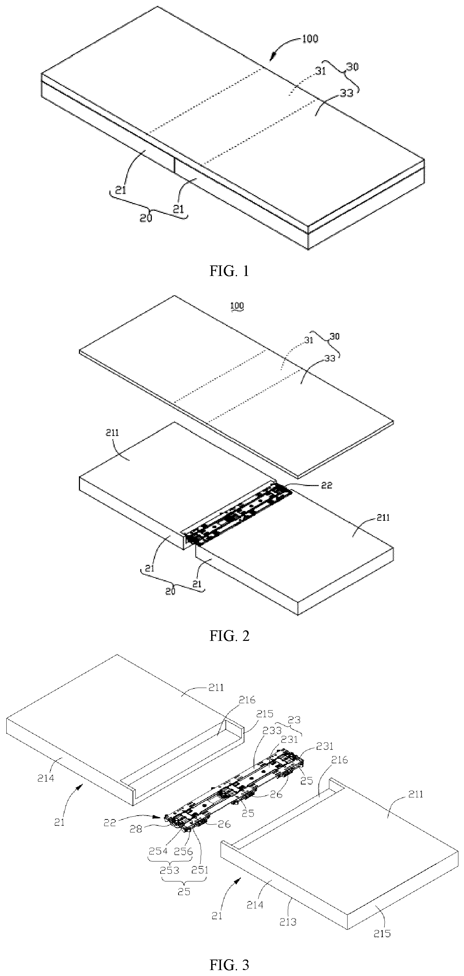

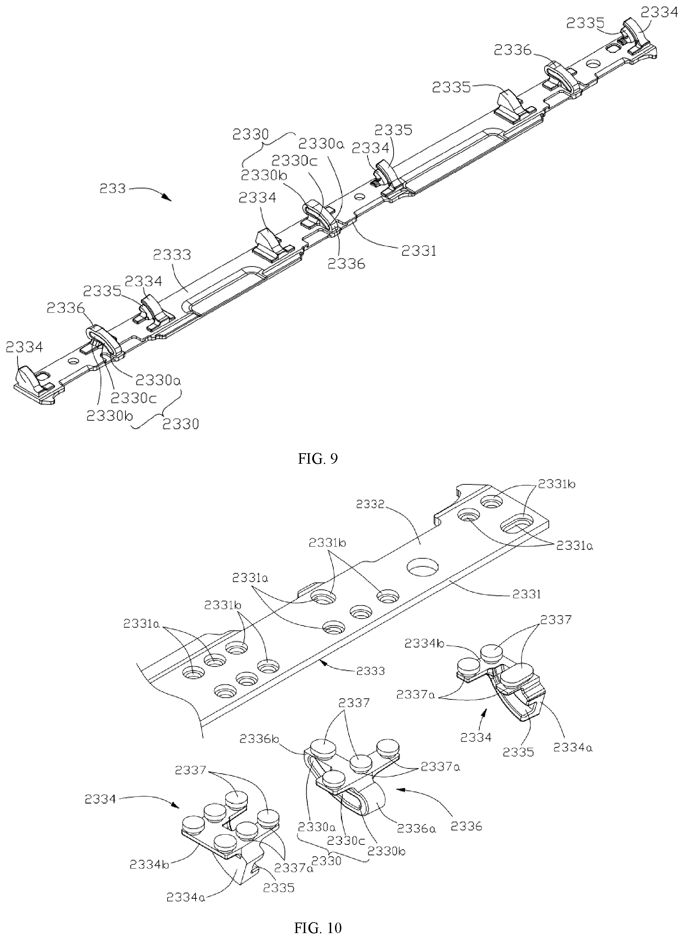

As shown in FIGS. 1 to 9, an electronic device 100 provided by some embodiments of the present disclosure includes a folding housing 20 and a flexible member 30 arranged on the folding housing 20. The flexible member 30 may include various flexible members with corresponding functions, such as a flexible display screen, a flexible touch screen, a flexible touch display screen etc., or a flexible member fixedly attached with flexible support plates, such as a flexible display screen attached with a flexible steel plate, a flexible touch screen, etc. The flexible member 30 may be folded or unfolded with the folding housing 20. The folding housing 20includes two frames 21 and a folding device 22 connected between the two frames 21. The flexible member 30 includes a bendable or foldable region 31 facing the folding device 22 and a non-bendable or non-foldable region 33 connected to each of two opposite sides of the bendable region 31. The non-bendable region 33 of the flexible member 30 is fixed to a front surface of a corresponding one of the two frames 21. The bendable region 31 may be attached to a front surface of the folding device 22. The bendable region 31 of the flexible member 30 may be folded or unfolded along with the folding device 22. The folding device 22 includes a support assembly 23, a rotating assembly 25, a folding-assisting assembly, and a back cover 28. The folding-assisting assembly includes a linkage assembly 26 and a limiting mechanism 27. The linkage assembly is connected to the rotating assembly 25, and the limiting mechanism 27 is connected to the linkage assembly 26. In some embodiments, the linkage assembly 26 is located between the rotating assembly 25 and the limiting mechanism 27. The support assembly 23 includes a middle support member 231 and a side support member 233 arranged on each of two opposite sides of the middle support member 231. The bendable region 31 of the flexible member 30 is attached to a front surface of the middle support member 231 and a front surface of the side support member 233. The side support member 233 includes a side support plate 2331 and a plurality of inserts. Each of the plurality of inserts is embedded in a back surface of the side support plate 2331. The rotating assembly 25 includes a positioning seat 251 and a rotating mechanism 253 arranged on each of two opposite sides of the positioning seat 251. The rotating mechanism 253 includes a rotating member 254 and a connecting member 256 rotatably connected to the rotating member 254. An end of the rotating members 254 away from the connecting member 256 is rotatably connected to the positioning seat 251. At least one of the plurality of inserts on the side support member 233 is rotatably connected to the connecting member 256. The linkage assembly 26 includes a pair of linkage members 264. An end of each of the linkage members 264 away from the other of the linkage members 264 is slidably connected to the connecting member 256 of the rotating mechanism 253 arranged on a corresponding side of the positioning seat 251. At least another one of the plurality of inserts on the side support member 233 is slidably and rotatably connected to a corresponding one of the linkage members 264. The connecting members 256 is rotatable with respect to the positioning seat 251, to drive the corresponding rotating member 254 and the corresponding linkage member 264 to rotate with respect to the positioning seat 251. Rotations of the rotating member 254 and the corresponding linkage member 264 are able to drive the side support member 233 to move, such that the two side support members 233 on the two opposite sides of the folding device are able to be synchronously folded or synchronously unfolded. The plurality of inserts include a rotating block 2334 and a limiting block 2336. The rotating block 2334 and the limiting block 2336 are embedded in the side support plate 2331. In some embodiments, the rotating block 2334 and the limiting block 2336 are embedded in the back surface of the side support plate 2331.

Each frame 21 of the electronic device 100 is connected to the corresponding connecting member 256 of the folding device 22. Each frame 21 drives the corresponding rotating member 254 and the corresponding linkage member 264 to rotate with respect to the positioning seat 251 through the corresponding connecting member 256. In this way, the two side support members 233 of the support assembly 23 may be folded or unfolded synchronously along with the rotations of the rotating mechanism 253 and the corresponding linkage member 264. The flexible member 30 is folded or unfolded along with the two side support members 233. The bendable region 31 may be folded into a waterdrop shape.

In some embodiments, the front surface refers to a surface facing the same orientation as a light-emitting surface of the flexible member 30. The back surface refers to a surface facing an opposite orientation with the light-emitting surface of the flexible member 30. The electronic device 100 may include any product and component with a display function, such as a mobile phone, a tablet, a display, a Liquid Crystal Display (LCD) panel, an Organic Light-Emitting Diode (OLED) panel, a television, a smartwatch, a Virtual Reality (VR) head-mounted display, an in-vehicle display, and so on. The term "connect/connected" in the description of the embodiments of the present disclosure includes a direct connection and an indirect connection. For example, "A being connected to B" include the situation that A and B are directly connected to each other, or A and B are connected through a third element C or more other elements. The term "connect/connected" may also include an integrated connection and a non-integrated connection. The integrated connection means that A and B are integrated with each other and are connected to each other. The non-integrated connection means that A and B are connected to each other but are not integrated with each other.

The folding device 22 of the electronic device 100 provided by some embodiments of the present disclosure includes the support assembly 23, the rotating assembly 25, and the linkage assembly 26. One end of the rotating member 254 is rotatably connected to the positioning seat 251, and the other end of the rotating member 254 is rotatably connected to the connecting member 256. One end of the corresponding linkage member 264 away from the positioning seat 251 is slidably connected to the connecting member 256. The side support member 233 on each of the two opposite sides of the folding device 22 is slidably and rotatably connected to the corresponding linkage member 264, and the side support member 233 is rotatably connected to the connecting member 256 of the rotating mechanism 253 arranged on a corresponding side of the positioning seat 251. In the process of the two frames 21 moving towards or moving away from each other through the rotation of the folding device 22, the connecting member 256 drives the rotating member 254 to rotate with respect to the positioning seat 251, and the connecting members 256 on the two opposite sides of the positioning seat 251 drive the two linkage members 264 to rotate synchronously with respect to each other. The rotations of the connecting members 256 and the linkage members 264 drive the two side support members 233 to be synchronously folded or unfolded with respect to each other. In this way, the flexible member 30 may be folded or flattened. Since the folding device 22 may be synchronously folded or flattened through the support assembly 23, the rotating assembly 25, and the linkage assembly 26. Compared with the related art in which the flexible member is supported by a hinge mechanism, the folding device 22 in some embodiments of the present disclosure has a simple structure, a low manufacturing cost, and a high reliability of connections between various components, and the overall strength may be improved. Moreover, in the related art, the support side plate generally includes a support plate and a plurality of connecting members, and each of the connecting members is welded or screwed to the support plate, which is cumbersome to assemble and has a high manufacturing cost. Compared with the related art, the side support plate 2331 of the side support member 233 in some embodiments of the present disclosure is fixed with the plurality of inserts by embedding connection, thus, the manufacturing process is simple without requiring an assembling process, which greatly reduces the manufacturing cost and is conducive to mass production.

In some embodiments, the folding device 22 includes one support assembly 23, three rotating assemblies 25, three linkage assemblies 26, and three limiting mechanisms. Each of the rotating assemblies 25 is connected to a corresponding one of the linkage assemblies 26 and a corresponding one of the limiting mechanisms 27 to form a combined structure. That is, the folding device 22 includes three combined structures. Two of the three combined structures are arranged at opposite ends of the back surface of the support assembly 23, and the rest combined structure is arranged at the middle of the back surface of the support assembly 23.

In some embodiments, the folding device 22 may include one support assembly 23, one rotating assembly 25, one linkage assembly 26, and one limiting mechanism 27. The rotating assembly 25, the linkage assembly 26, and the limiting structure 27 are connected to each other to form a combined structure. The combined structure is connected to the back surface of the support assembly 23.

In some embodiments, the folding device 22 may include one support assembly 23, two rotating assemblies 25, two linkage assemblies 26, and two limiting mechanisms 27. One of the two rotating assemblies 25, one of the two linkage assemblies 26, and one of the two limiting mechanisms 27 are connected to each other to form a combined structure. The other of the two rotating assemblies 25, the other of the linkage assemblies 26, and the other of the limiting mechanisms 27 are connected to each other to form another combined structure. The two combined structures are connected to the back surface of the support assembly 23 and are spaced apart from each other.

In some embodiments, the folding device 22 may include one support assembly 23, more than three rotating assemblies 25, more than three linkage assemblies 26, and more than three limiting mechanisms 27. The more than three assemblies 25 are arranged at the back surface of the support assembly 23 and are spaced apart from each other along a lengthwise direction of the support assembly 23. The more than three linkage assemblies 26 are respectively connected to the three rotating assemblies 25 in one-to-one correspondence, and the more than three limiting mechanisms 27 are respectively connected to the three linkage assemblies 26 in one-to-one correspondence.

As shown in FIGS. 1 to 3, the connecting member 256 on each of the two opposite sides of the folding device 22 is fixedly connected to a corresponding one of the two frames 21. The connecting member 256 and the corresponding frame 21 may be fixed to each other through a screw, a snapping member, an adhesive, and so on. When one of the two frames 21 is folded or flattened with respect to the other of the two frames 21, the corresponding rotating mechanism 253 is driven to rotate with respect to the positioning seat 251. The rotating mechanisms 253 on the two opposite sides of the positioning seat 251 drive the two side support members 233 to rotate and slide synchronously with respect to the positioning seat 251 through the linkage assembly 26, until the two side support members 233 and the middle support member 231 are synchronously folded into a waterdrop shape or synchronously unfolded to form a flat shape. The bendable region 31 of the flexible member 30 is folded into a waterdrop shape or unfolded into a flat shape along with the bendable region 31.

As shown in FIG. 2 and FIG. 3, each frame 21 includes a front surface 211, a back surface 213, two opposite side surfaces 214, and two end surfaces 215. The folding device 22 is connected between two end surfaces 215 of the two frames 21. The non-bendable region 33 of the flexible member 30 is connected to the front surface 211 of the corresponding frame 21. One of the two end surfaces 215 of each frame 21 facing the folding device 22 defines a receiving groove 216. The receiving groove 216 penetrates the front surface 211 of the corresponding frame 21. Each of the two opposite sides of the folding device 22 is received in the receiving groove 216 of the corresponding frame 21. Each connecting member 256 is fixedly connected to the corresponding frame 21. The back surface 213 of each frame 21 defines a plurality of receiving spaces (not shown in the drawings) configured to mount electronic components such as a circuit board, a battery, and so on.

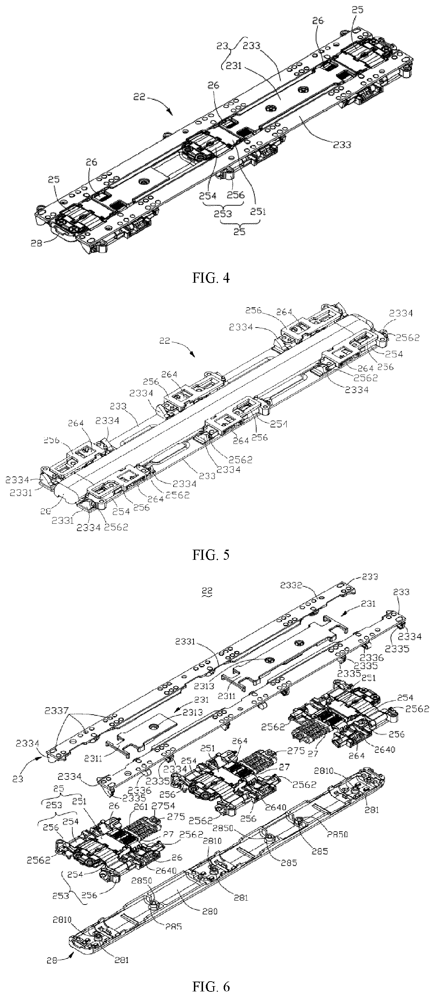

As shown in FIGS. 5 to 9, the middle support member 231 is a rectangular plate. The rectangular plate includes a front surface 2311 and a back surface 2312 opposite to the front surface 2311. The front surface 2311 of the middle support member 231 defines a countersunk hole 2313. The countersunk hole 2313 penetrates the back surface 2312. The side support plate 2331 is implemented as a strip plate. The side support plate 2331 includes a front surface 2332 and a back surface 2333 opposite to the front surface 2332. The rotating block 2334 and the limiting block 2336 are embedded in the back surface 2333 of the side support plate 2331. In some embodiments, the side support plate 2331 is integrally formed by plastic materials by means of injection moulding. In some embodiments, after placing the rotating block 2334 and the limiting block 2336 in a mould, plastic materials are injected into a mould cavity of the mould, enabling the plurality of inserts to be integrated with the side support plate 2331 to form a one-piece structure. That is to say, the side support plate 2331 and the plurality of inserts are formed integrally.

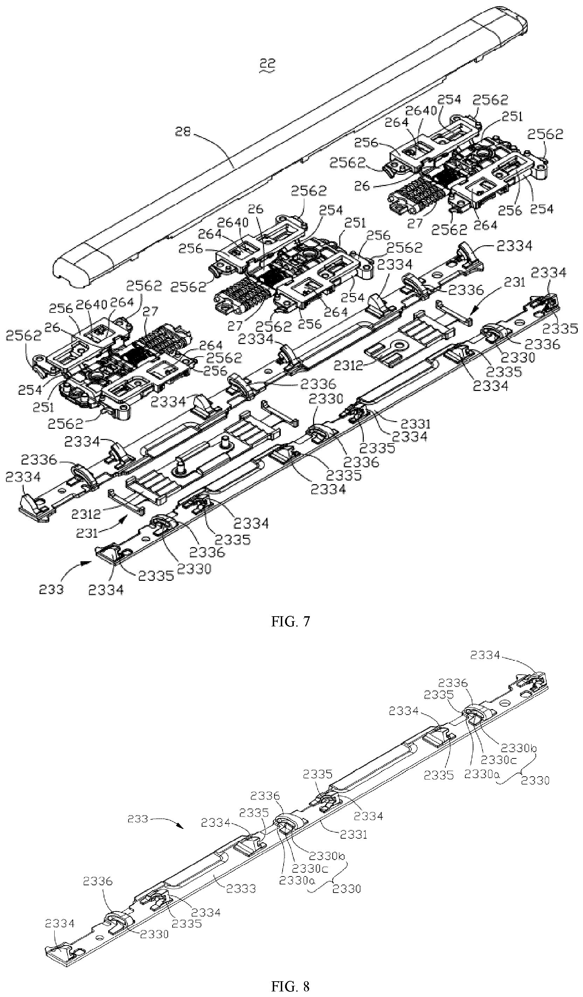

As shown in FIGS. 8 to 12 together, in some embodiments, the side support member 233 includes three pairs of rotating blocks 2334 and three limiting blocks 2336. The three pairs of rotating blocks 2334 are embedded in the back surface 2333 of the side support plate 2331 and are spaced apart from each other. The three limiting blocks 2336 are embedded in the back surface 2333 of the side support plate 2331 and are spaced apart from each other. Each pair of rotating blocks 2334 is arranged with a corresponding one of the limiting blocks 2336 therebetween. In some embodiments, two pairs of rotating blocks 2334 are arranged at two opposite ends of the back surface 2333 of the side support plate 2331, and the rest pair of rotating blocks 2334 is arranged adjacent to the middle of the back surface 2333 of the side support plate 2331. Each pair of the rotating blocks 2334 is arranged with a corresponding one of the limiting blocks 2336 therebetween. Each limiting block 2336 is arranged on the side support plate 2331 at a side away from the middle support member 231. Each limiting block 2336 has a spacing from the adjacent rotating block 2334. The spacing is able to satisfy the travel of the backward movement of the slanting tip on the mould, and thus the mould is manufacturable.

In some embodiments, the side support member 233 may include a pair of rotating blocks 2334 and one limiting block 2336. The pair of rotating blocks 2334 may be embedded at any position of the back surface 2333 of the side support plate 2331, and the limiting block 2336 is arranged between the pair of rotating blocks 2334. A combined structure formed by connecting one rotating assembly 25, one linkage assembly 26, and one limit mechanism 27 to each other is arranged between the side support member 233 and the back cover 28.

In some embodiments, the side support member 233 may include two pairs of rotating blocks 2334 and two limiting blocks 2336. The two pairs of rotating blocks 2334 are embedded in the back surface 2333 of the side support plate 2331 and are spaced apart from each other. A corresponding one of the two limiting blocks 2336 is embedded in the back surface 2333 of the side support plate 2331 and located between each pair of rotating blocks 2334. In some embodiments, the two pairs of rotating blocks 2334 are respectively embedded at two opposite ends of the back surface 2333 of the side support plate 2331, and a corresponding one of the two limiting blocks 2336 is arranged between each pair of rotating blocks 2334. Two combined structures are formed by two rotating assemblies 25, two linkage assemblies 26, and two limiting mechanisms 27 in one-to-one correspondence, and are arranged between the side support member 233 and the back cover 28.

In some embodiments, the side support member 233 may include more than three pairs of rotating blocks 2334 and more than three limiting blocks 2336. The more than three pairs of rotating blocks 2334 are embedded in the back surface 2333 of the side support member 233 and are spaced apart from each other. The more than three pairs of rotating blocks 2334 are arranged in a lengthwise direction of the side support member 233. A corresponding one of the limiting blocks 2336 is embedded in the back surface 2333 of the side support member 2331 and located between each pair of rotating blocks 2334. More than three combined structures are formed by respectively connecting more than three rotating assemblies 26, more than three linkage assemblies 26, and more than three limiting mechanisms 27 in one-to-one correspondence, and are arranged between the side support member 233 and the back cover 28.

The inserts and the side support plate 2331 are made of different materials. The hardness of each insert is greater than or equal to that of the side support plate 2331. In some embodiments, the inserts may be made of, but is not limited to, materials such as rigid carbon fiber, stainless steel, aluminum alloy, or magnesium alloy. That is to say, the rotating block 2334 and the limiting block 2336 may be made of, but are not limited to, materials such as rigid carbon fiber, stainless steel, aluminum alloy, or magnesium alloy. The plastic material used for the injection moulding of the side support plate 2331 may be, but is not limited to, Nylon, Polyamide (PA) added with carbon fiber (CF) or glass fiber (GF), polyetheretherketone (PEEK) added with CF or GF, etc. The side support member 233 formed by injection moulding using the above plastic materials and the inserts has a strong hardness, and can meet the support function of the side support member 233.

Each insert includes one or more connecting portions 2337 embedded in the side support plate 2331. That is, each of the rotating blocks 2334 and the limiting blocks 2336 includes one or more connecting portions 2337. The rotating block 2334 and the limiting block 2336 are respectively embedded in the side support plate 2331 through the corresponding connecting portions 2337. According to the invention, the rotating block 2334 further includes a rotating portion 2334a and a support portion 2334b arranged on the rotating portion 2334a, and the one or more connecting portions 2337 are arranged on a side of the support portion 2334b away from the rotating portion 2334a. In some embodiments, the rotating portion 2334a may be implemented as an arcuate sheet or plate. The support portion 2334b may be implemented as a support sheet or plate arranged on the front surface of the arcuate sheet. Each connecting portion 2337 may be implemented as a connecting column protruding from a side of the support portion 2334b away from the rotating portion 2334a. The support portion 2334b may be implemented as, but is not limited to, a U-shaped support sheet, a rectangular support sheet an annular support sheet, or the like. According to the invention, a plurality of connecting portions 2337 protrude from a side surface of the support portion 2334b away from the rotating portion 2334a. The limiting block 2336 further includes a limiting portion 2336a and a support portion 2336b arranged on a front surface of the limiting portion 2336. The one or more connecting portions 2337 are arranged on a side of the support portion 2336b away from the limiting portion 2336a. In some embodiments, the limiting portion 2336a may be implemented as an arcuate sheet, the support portion 2336a may be implemented as a T-shaped support sheet arranged on the front surface of the arcuate sheet. Each connecting portion 2337 may be implemented as a connecting column protruding from a side of the T-shaped support sheet away from or opposite to the limiting portion 2336a. In some embodiments, the support portion 2336b may also be, but is not limited to, a rectangular support sheet, a U-shaped support sheet, a ring-shaped support sheet, or the like. A plurality of connecting portions 2337 may be arranged on the side of the support portion 2336b away from or opposite to the limiting portion 2336a.

In some embodiments, each connecting portion 2337 defines a positioning recess 2337a, the side support plate 2331 has one or more flanges 2331a, and each flange 2331a corresponds to and faces the positioning recess 2337a defined in a corresponding one of the one or more connecting portions 2337. Each flange 2331a is engaged into the positioning recess 2337a defined in the corresponding connecting portion 2337. In some embodiments, the side support plate 2331 defines one or more through holes 2331b. Each flange 2331a protrudes from an inner peripheral surface of a corresponding one of the one or more through holes 2331b of the side support plate 2331. Each positioning recess 2337a is defined in an outer peripheral surface of the corresponding connecting portion 2337. Each connecting portion 2337 is received in the corresponding one of the through holes 2331b, and each flange 2331a is engaged into the positioning recess 2337a defined in the corresponding connecting portion 2337. Each connecting portion 2337 may be implemented as, but is not limited to, a cylindrical column, a rectangular column, a polygonal column, a waist-shaped column, or the like. Each through hole 2331b may be implemented as, but is not limited to, a circular hole, a rectangular hole, a polygonal hole, a waist-shaped hole, or the like.

In some embodiments, the positioning recesses 2337a are continuously or intermittently defined or arranged in a ring on a plane substantially parallel to the back surface 2333 of the side support plate 2331. The flanges 2331a are continuously or intermittently arranged in a ring on a plane substantially parallel to the back surface 2333 of the side support plate 2331. Each flange 2331a is engaged into the positioning recess 2337a defined in the corresponding connecting portion 2337. In some embodiments, the positioning recesses 2337a are continuously arranged in a ring on a plane substantially parallel to the back surface 2333 of the side support plate 2331. The flanges 2331a are continuously arranged in a ring on a plane substantially parallel to the back surface 2333 of the side support plate 2331.

In some embodiments, each connecting portion 2337 includes a flange. The side support plate 2331 defines one or more positioning recesses, and each of the one or more positioning recesses faces the flange of the corresponding connecting portion 2337. In some embodiments, each flange protrudes from the outer peripheral surface of the corresponding connecting portion 2337, and the inner peripheral surface of each through hole 2331b of the side support plate 2331 defines a corresponding one of the positioning recesses. Each flange is engaged into the corresponding positioning recess. In some embodiments, the positioning recesses 2337a are continuously or intermittently defined or arranged in a ring on a plane substantially parallel to the back surface 2333 of the side support plate 2331. The flanges 2331a are continuously or intermittently arranged in a ring on a plane substantially parallel to the back surface 2333 of the side support plate 2331.

As shown in FIGS. 4 to 10, a side of the side support plate 2331 away from the positioning seat 251 is rotatably connected to the connecting member 256. In some embodiments, the side of the side support member 233 away from the positioning seat 251 is connected to the connecting member 256 through a cooperation or an engagement between a first arc-shaped groove and a first arc-shaped rail. The first arc-shaped groove is defined in one of the side support member 233 and the connecting member 256. The first arc-shaped rail is arranged in the other of the side support member 233 and the connecting member 256. In some embodiments, the rotating block 2334 defines a first arc-shaped groove 2335. In some embodiments, the first arc-shaped groove 2335 is defined in the rotating portion 2334a. The connecting member 256 is provided with a first arc-shaped rail 2562 slidably inserted in the first arc-shaped groove 2335. An axis of the first arc-shaped groove 2335 is collinear with an axis of rotation between the side support member 233 and the connecting member 256. The first arc-shaped groove 2335 is defined on a side surface of the rotating portion 2334a facing the connecting member 256. One end of the first arc-shaped groove 2335 penetrates a surface of the rotating portion 2334a away from the middle support member 231, and the other end of the first arc-shaped groove 2335 extends to the back surface 2333 of the side support member 233. The first arc-shaped groove 2335 is curved in a direction away from the back surface 2333, that is, the middle of the first arc-shaped groove 2335 is curved in the direction away from the back surface 2333.

In some embodiments, a side surface of the rotating portion 2334a of each rotating block 2334 in each pair of the rotating blocks 2334, which faces a side surface of the rotating portion 2334a of the other rotating block 2334 in each pair of the rotating blocks 2334, defines the first arc-shaped groove 2335. The axes of the two first arc-shaped grooves 2335 defined on the two side surfaces of the two rotating portions 2334 facing each other are collinear with each other. One end of the first arc-shaped groove 2335 penetrates a surface of the rotating portion 2334a away from the middle support member 231.

In some embodiments, a side surface of the rotating portion 2334a of each rotating block 2334 in each pair of the rotating blocks 2334, which faces away from a side surface of the rotating portion 2334a of the other rotating block 2334 in each pair of the rotating blocks 2334, defines the first arc-shaped groove 2335. The axes of the two first arc-shaped grooves 2335 defined on the two side surfaces of the two rotating portions 2334 facing away from each other are collinear with each other. One end of the first arc-shaped groove 2335 penetrates a surface of the rotating portion 2334a away from the middle support member 231. The first arc-shaped groove 2335 is curved in the direction away from the back surface 2333. Each of two opposite ends of the connecting member 256 is provided with the first arc-shaped rail 2562 rotatably received in the corresponding first arc-shaped groove 2335.

In some embodiments, one of two opposite side surfaces of the rotating portion 2334a of one rotating block 2334 in each pair of the rotating blocks 2334 defines a first arc-shaped groove 2335. One of two opposite side surfaces of the rotating portion 2334a of the other rotating block 2334 in each pair of the rotating blocks 2334 defines another first arc-shaped groove 2335. The axes of the two first arc-shaped grooves 2335 are collinear with each other. Each of the two opposite ends of the connecting member 256 is provided with the first arc-shaped rail 2562 rotatably received in the corresponding first arc-shaped groove 2335.

In some embodiments, each of two opposite ends at the side of the connecting member 256 away from the positioning seat 251 defines the first arc-shaped groove. The first arc-shaped groove is curved in a direction away from the side support plate 2331. The axes of the two first arc-shaped grooves 2335 defined at two opposite ends of the connecting member 256 are collinear with each other. The rotating block 2334 is disposed on the side support member 233 at a position facing each of two opposite ends of the connecting member 256. The first arc-shaped rail is provided on the rotating block 2334 and rotatably received in the first arc-shaped groove.

As shown in FIGS. 6 to 10, the side support member 233 is connected to the corresponding linkage member 264 by a cooperation or mating connection between a sliding-limiting groove 2330 and a sliding-guiding portion 2640. The sliding-limiting groove 2330 is defined in one of the side support member 233 and the corresponding linkage member 264, and the sliding-guiding portion 2640 is arranged in the other of the side support member 233 and the corresponding linkage member 264. In some embodiments, the sliding-limiting groove 2330 is defined in the limiting block 2336 of the side support member 233. In some embodiments, the sliding-limiting groove 2330 is defined in the limiting portion 2336a, the sliding-guiding portion 2640 is arranged in the corresponding linkage member 264, and the sliding-guiding portion 2640 slidably passes through the sliding-limiting groove 2330. The sliding-limiting groove 2330 extends obliquely in a direction away from the side support plate 2331. Each limiting block 2336 defines the sliding-limiting groove 2330, and the sliding-limiting groove 2330 may or may not penetrate two opposite sides of the limiting block 2336 along a direction substantially parallel to a lengthwise direction of the side support plate 2331. In some embodiments, the sliding-limiting groove 2330 defined in each limiting block 2336 penetrates two side surfaces of the limiting portion 2336a opposite to each other. The sliding-limiting groove 2330 extends from one side of the side support plate 2331 to the opposite side of the side support plate 2331.

The sliding-limiting groove 2330 includes a first limiting section 2330a and a second limiting section 2330b located at two opposite ends of the sliding-limiting groove 2330, and a sliding-guiding section 2330c located between the first limiting section 2330a and the second limiting section 2330b. The first limiting section 2330a is located at a side of the sliding-limiting groove 2330 away from the rotating block 2334, and the second limiting section 2330b is located at a side of the sliding-limiting groove 2330 close to the rotating block 2334. The first limiting section 2330a, the sliding-guiding section 2330c, and the second limiting section 2330b are in communication with each other. The second limiting section 2330b is disposed farther away from the side support plate 2331 than the first limiting section 2330a. When the two side support members 233 are in a fully folded state, the sliding-guiding portion 2640 is positioned at the first limiting section 2330a, so as to prevent the side support members 2330a from being further folded. When the two side support members 233 are in a flattened state, the sliding-guiding portion 2640 is positioned at the second limiting section 2330b, so as to prevent the side support members 233 from being further flattened. In some embodiments, the sliding-limiting groove 2330 is an arc-shaped groove. The sliding-limiting groove 2330 is curved in a direction away from the back surface 2333. In some embodiments, the sliding-guiding section 2330c is curved in the direction away from the back surface 2333. In some embodiments of the present disclosure, the mating connection between the sliding-limiting groove 2330 and the sliding-guiding portion 2640 configured between the side support member 233 and the corresponding linkage member 264 can reduce the overall width of the folding device 22, thus, the internal space of the housing 20 occupied by the folding device 22 may be reduced, thereby facilitating the layout of other components, such as the main board, the battery, or the like.

In some embodiments, the sliding-limiting groove 2330 may be defined in the corresponding linkage member 264, the sliding-guiding portion 2640 may be arranged in the side support member 233, and the sliding-guiding portion 2640 may slidably pass through the sliding-limiting groove 2330.

As shown in FIGS. 4 to 7 and FIGS. 13 to 18, an end of the rotating member 254 away from the connecting member 256 is rotatably connected to the positioning seat 251. A side of the side support member 233 away from the middle support member 231 is rotatably connected to the connecting member 256. The linkage assembly 26 is connected between the positioning seat 251 and the two connecting members 256 arranged on two opposite sides of the positioning seat 251. The side support member 233 and the connecting member 256 are rotatably connected to each other through a cooperation between the first arc-shaped groove 2335 and the first arc-shaped rail 2562. The positioning seat 251 and the rotating member 254 are rotatably connected to each other through a cooperation between a second arc-shaped groove 2511 and a second arc-shaped rail 2541. That is, the second arc-shaped groove 2511 is defined in one of the positioning seat 251 and the connecting member 256, and the second arc-shaped rail 2541 is arranged in the other of the positioning seat 251 and the connecting member 256. In some embodiments, the first arc-shaped rail 2562 at each end of the connecting member 256 is rotatably inserted in the corresponding first arc-shaped groove 2335 of the side support member 233. In this way, the connecting member 256 and the side support member 233 may rotate with respect to each other along the first arc-shaped groove 2335, an axis of the first arc-shaped rail 2562 is collinear with an axis of the first arc-shaped groove 2335, and the axis of the first arc-shaped rail 2562 is colinear with the axis of rotation between the side support member 233 and the connecting member 256. The positioning seat 251 defines the second arc-shaped groove 2511. The rotating member 254 is arranged with the second arc-shaped rail 2541 facing the second arc-shaped groove 2511. In this way, the rotating member 254 and the positioning seat 251 may rotate with respect to each other along the second arc-shaped groove 2511, axes of the second arc-shaped groove 2511 and the second arc-shaped rail 2541 are collinear with each other, and the axis of the second arc-shaped rail 2541 is collinear with the axis of rotation between the rotating member 254 and the positioning seat 251.

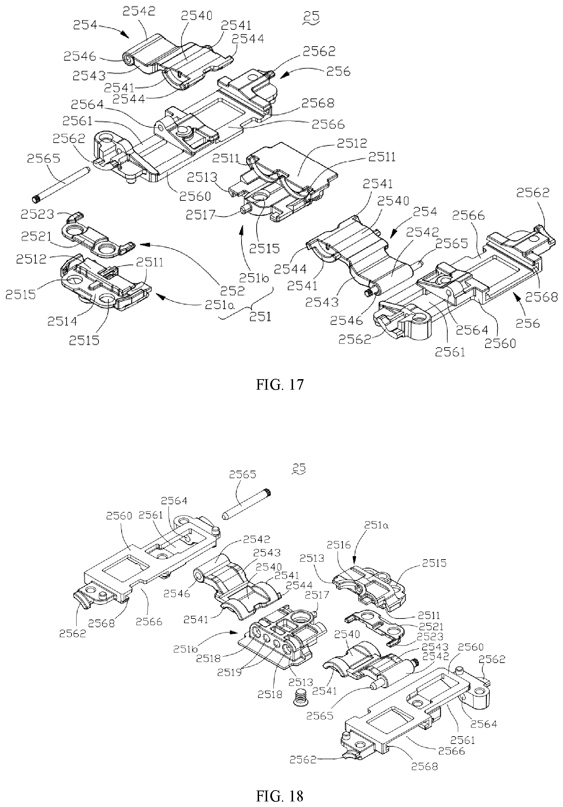

As shown in FIG. 17 and FIG. 18, the positioning seat 251 includes a first seat body 251a and a second seat body 251b connected to the first seat body 251a. An end of the rotating member 254 away from the connecting member 256 is rotatably connected between the first seat body 251a and the second seat body 251b. In some embodiments, each of the first seat body 251a and the second seat body 251b defines the second arc-shaped groove 2511. The second arc-shaped rail 2541 of the rotating member 254 is rotatably received in the second arc-shaped groove 2511. The first seat body 251 includes a front surface 2512, a back surface opposite to the front surface 2512, two opposite side surfaces 2513, and two opposite end surfaces. The side surface 2513 of the first seat body 251a facing the second seat body 251b defines a pair of second arc-shaped grooves 2511. Each of the two opposite ends of each of the second arc-shaped grooves 2511 penetrates the front surface 2512. Axes of the two second arc-shaped grooves 2511 on the first seat body 251a are substantially parallel to each other. A side of the front surface 2512 of the first seat body 251a away from the second arc-shaped groove 2511 defines a positioning recess 2514. Each of the two second arc-shaped grooves 2511 is in communication with the positioning recess 2514. The first seat body 251a defines a connecting hole 2515 at each of the two opposite ends of the bottom surface of the positioning recess 2514. The side surface 2513 of the first seat body 251a facing the second seat body 251b defines an engaging hole 2516.

The second seat body 251b includes a front surface 2512, a back surface opposite to the front surface 2512, two opposite side surfaces 2513, and two opposite end surfaces. The side surface 2513 of the second seat body 251b facing the first seat body 251a defines a receiving space at a side close to the front surface 2512. The receiving space is configured to receive the rotating member 254. The second seat body 251b defines a pair of second arc-shaped grooves 2511 on a side surface of the receiving space. Axes of the pair of the second arc-shaped grooves 2511 on the side surface of the receiving space are parallel to each other. After the first seat body 251a is connected to the second seat body 251b, the pair of the second arc-shaped grooves 2511 defined in the second seat body 251b directly face the pair of the second arc-shaped grooves 2511 defined in the first seat body 251a in one-to-one correspondence. The second seat body 251b defines a connecting hole 2515 on the bottom surface of the receiving space. A locking member, such as a screw, passes through the connecting hole 2515 and is connected to the back cover 28. In this way, the positioning seat 251 may be connected to the back cover 28. The side 2513 of the second seat body 251b facing the first seat body 251a is arranged with an engaging column 2517. Each of two opposite ends of the side surface 2513 of the second seat body 251b away from the first seat body 251a defines a connecting hole 2518. The middle of the side surface 2513 of the second seat body 251b away from the first seat body 251a defines a shaft hole 2519. A cover plate extends from the front surface 2512 of the second seat body 251b in a direction away from the engaging column 2517.

The positioning seat 251 further includes a stopping member 252. The stopping member 252 is configured to prevent the second arc-shaped rail 2541 from being disengaged from the corresponding second arc-shaped groove 2511. The stopping member 252 includes a positioning portion 2521 and a stopping portion 2523 connected to an end of the positioning portion 2521. The positioning portion 2521 may be received and fixed in the positioning recess 2514 of the first seat body 251a. The stopping portion 2523 may be implemented as a stopping bar protruding from two opposite ends of the positioning portion 2521. The stopping bar is configured to stop the second arc-shaped rail 2541 from being disengaged from the corresponding second arc-shaped groove 2511. The positioning portion 2521 defines two through holes corresponding to the two connecting holes 2515 of the first seat body 251a in one-to-one correspondence. Two locking members respectively pass through the two through holes and be locked in the two connecting holes 2515 of the first seat body 251a.

The rotating member 254 includes a first rotating block 2540, a second rotating block 2542, and a connecting portion 2543 connected between the first rotating block 2540 and the second rotating block 2542. The first rotating block 2540 is rotatably connected to the positioning seat 251. The second rotating block 2542 is rotatably connected to the corresponding connecting member 256. The first rotating block 2540 is arranged with a second arc-shaped rail 2541. The second rotating block 2542 is rotatably connected to the connecting member 256 through a pivot shaft. At least one side surface of the first rotating block 2540 has the second arc-shaped rail 2541 protruding therefrom. In some embodiments, each of two opposite side surfaces of the first rotating block 2540 has the second arc-shaped rail 2541 protruding therefrom, the axes of the second arc-shaped rails 254 are collinear with each other. A stopping block 2544 protrudes from an end of the second arc-shaped rail 2541 away from the connecting portion 2543 along an axis of the second arc-shaped rail 2541. The second rotating block 2542 defines a shaft hole 2546 along a direction parallel to the axis of the second arc-shaped rail 2541. In some embodiments, the second rotating block 2542 is a rotating cylinder, and an axis of the rotating cylinder is parallel to the axis of the second arc-shaped rail 2541.

In some embodiments, the second arc-shaped groove 2511 on the positioning seat 251 and the second arc-shaped rail 2541 on the rotating member 254 may be interchangeable with each other. For example, the arc-shaped groove may be defined on the side surface of the first rotating block 2540, and the arc-shaped rail facing the arc-shaped groove may be arranged on the positioning seat 251. The arc-shaped rail may be rotatably inserted in the arc-shaped groove. The axis of the arc-shaped groove, the axis of the arc-shaped rail, and the axis of rotation between the rotating member 254 and the positioning seat 251 may be collinear with each other.

The connecting member 256 is strip-shaped. In some embodiments, the connecting member 256 includes a rectangular connecting plate 2560. Each of two opposite ends of the connecting plate 2560 is arranged with the first arc-shaped rail 2562. One end of the front surface of the connecting plate 2560 defines a receiving opening 2561. The receiving opening 2561 of the connecting plate 2560 is configured to receive the second rotating block 2542. That is, the second rotating block 2542 may be rotatably received in the receiving opening 2561 to enable the second rotating block 2542 to be rotatably connected to the connecting member 256. The connecting member 256 defines a shaft hole 2564 on each of two opposite sides of the receiving opening 2561 along the direction substantially parallel to the axis of the first arc-shaped rail 2562. A pivot shaft 2565 is configured to be inserted in the shaft hole 2564. The other end of the connecting plate 2560 away from the receiving opening 2561 defines a sliding-guiding space 2566 along a direction substantially perpendicular to the axis of the first arc-shaped rail 2562. The sliding-guiding space 2566 penetrates the two opposite side surfaces of the connecting plate 2560. The connecting plate 2560 defines a sliding-guiding groove 2568 on each of two opposite side surfaces of the sliding-guiding space 2566 along the direction substantially perpendicular to the axis of the first arc-shaped rail 2562. That is, the sliding-guiding groove 2568 extends in a direction substantially perpendicular to the axis of rotation between the linkage member 264 and the positioning seat 251.

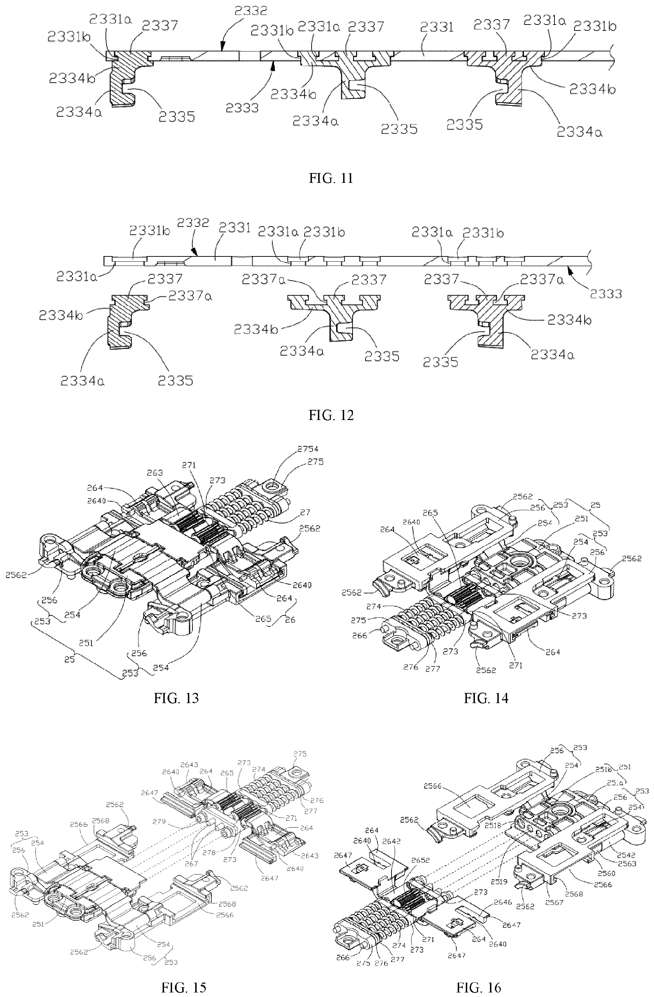

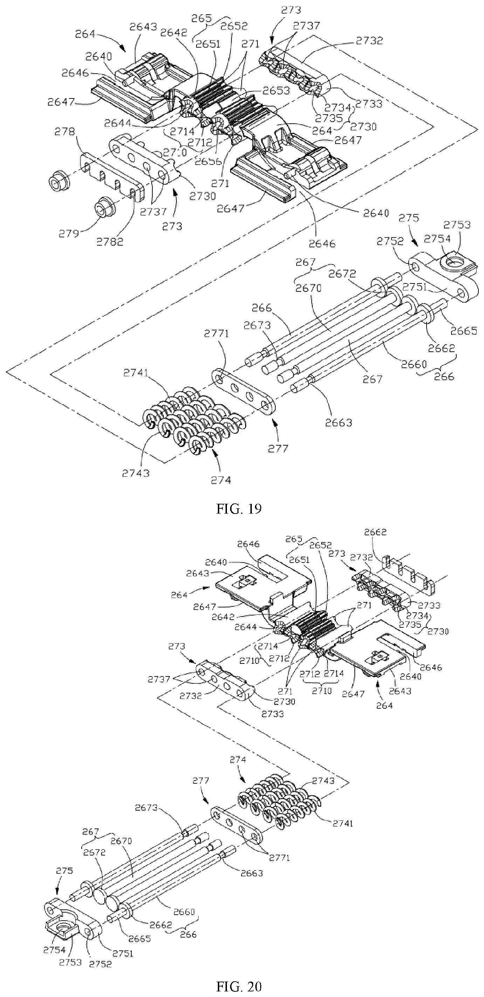

As shown in FIGS. 13-16 and FIGS. 19-20, the linkage assembly 26 further includes a gear group 265, two first rotating shafts 266, and two second rotating shafts 267. The gear group is arranged on the two first rotating shafts 266 and the two second rotating shafts 267. Each of the two linkage members 264 is rotatably sleeved on a corresponding one of the two first rotating shafts 266. One end of each of the two rotating shafts 266 is inserted into the positioning seat 251. Each linkage member 264 is rotatable around the corresponding first rotating shaft 266. The two linkage members 264 may be synchronously folded or flattened through the gear group 265.

Each linkage member 264 includes a sleeve 2642 and a connecting rod 2643 connected to an outer periphery of the sleeve 2642. The sleeve 2642 defines a shaft hole 2644 along an axial direction thereof. The shaft hole 2644 penetrates two opposite ends of the sleeve 2642, and the corresponding first rotating shaft 266 is inserted in the shaft hole 2644. The connecting rod 2643 is a rectangular plate. An end of the connecting rod 2643 away from the sleeve 2642 defines a sliding-guiding opening 2646 along a direction perpendicular to an axial direction of the sleeve 2642. The connecting rod 2643 of one linkage member 264 is arranged with the sliding-guiding opening 2646 in the sliding-guiding portion 2640. In some embodiments, the sliding-guiding portion 2640 is a sliding-guiding column inserted in the connecting rod 2643. An end of each linkage member 264 away from the gear group 265 is slidably arranged in and passes through the sliding-guiding groove 2568 of the corresponding connecting member 256. In some embodiments, each of the two opposite sides of the connecting rod 2643 is arranged with a sliding-guiding bar 2647. The sliding-guiding bar 2647 extends along a direction parallel to a lengthwise direction of the sliding-guiding opening 2646. The sliding-guiding bar 2647 may be slidably inserted in the guide sliding groove 2568 of the connecting member 256.

Each linkage member 264 is connected to a pushing member 271. In some embodiments, the pushing member 271 is connected to each of the two opposite ends of the sleeve 2642. The pushing member 271 includes a first cam 2710 arranged at an end surface of the sleeve 2642, the first cam 2710 is sleeved on the first rotating shafts 266, and an axis of the first cam 2710 is collinear with an axis of the sleeve 2642. The first cam 2710 includes a concave-convex surface arranged at one end of the sleeve. The concave-convex surface includes a first convex portion 2712 and a first concave portion 2714. The first convex portion 2712 and the first concave portion 2714 are successively and alternatively arranged at intervals along the peripheral direction of the sleeve 2642. The numbers of the first convex portions 2712 and the first concave portions 2714 may be set as required. For example, the first cam 2710 may include one first convex portion 2712 and one first concave portion 2714, two first convex portions 2712 and two first concave portions 2714, three first convex portions 2712 and three first concave portions 2714, fourth first convex portions 2712 and fourth first concave portions 2714, etc. In some embodiments, the first cam 2710 includes three first convex portions 2712 and three first concave portions 2714 arranged at intervals along the peripheral direction of the sleeve 2642.

In some embodiments, an axis of the first cam 2710 at each of the two opposite ends of the sleeve 2642, an axis of a first gear 2651 on the outer periphery of the sleeve 2642, and the axis of the sleeve 2642 are collinear with each other. The concave-convex surfaces of the two first cams 2710 at the two opposite ends of the sleeve 2642 are of the same structure, and the two concave-convex surfaces of the two first cams 2710 are symmetrical.

The gear group 254 includes two first gears 2651 and two second gears 2652. Each first gear 2651 is sleeved on the corresponding first rotating shaft 266. Each second gear 2652 is sleeved on the corresponding second rotating shaft 267. The two second gears 2652 are engaged with each other. Each second gears 2652 is engaged with the corresponding first gear 2651. Each first gear 2651 is arranged on the outer periphery of the corresponding sleeve 2642. In some embodiments, teeth of each first gear 2651 are arranged along the peripheral direction of the sleeve 2642 with an angle of rotation in the range of greater than or equal to 90 degrees to less than or equal to 180 degrees. That is, greater than one-fourth and less than one-half of the outer periphery of the sleeve 2642 is arranged with the first gear 2651. Each second gear 2652 includes a sleeve 2653. Teeth of the second gear 2652 are arranged on an outer periphery of the sleeve 2653. The teeth of the second gear 2652 are arranged into a ring along a peripheral direction of the sleeve 2642. A shaft hole 2656 is defined at the middle of the second gear 2652 along an axial direction of the second gear 2652. Each second rotating shaft 267 is inserted in the shaft hole 2656 of the corresponding second gear 2652. Each of two opposite ends of the second gear 2652 is arranged with a pushing member 271. The pushing member 271 includes a first cam 2710 arranged at an end surface of the sleeve 2653. The first cam 2710 on the second gear 2652 is arranged on the corresponding second rotating shaft 267. An axis of the first cam 2710 is collinear with an axis of the sleeve 2653. The first cam 2710 includes a concave-convex surface arranged at one end of the sleeve 2653. The concave-convex surface includes a first convex portion 2712 and a first concave portion 2714. The first convex portion 2712 and the first concave portion 2714 are successively and alternatively arranged at intervals along the peripheral direction of the sleeve 2653. The numbers of the first convex portions 2712 and the first concave portions 2714 may be set as required. For example, the first cam 2710 may include one first convex portion 2712 and one first concave portion 2714, two first convex portions 2712 and two first concave portions 2714, three first convex portions 2712 and three first concave portions 2714, fourth first convex portions 2712 and fourth first concave portions 2714, etc. In some embodiments, the first cam 2710 includes three first convex portions 2712 and three first concave portions 2714 arranged at intervals along the peripheral direction of the sleeve 2653.

In some embodiments, the axis of the first cam 2710 at each of the two opposite ends of the sleeve 2653, the axis of the second gear 2652 on the outer periphery of the sleeve 2653, and the axis of the sleeve 2654 are collinear with each other. The concave-convex surfaces of the two first cams 2710 at the two opposite ends of the sleeve 2653 are of the same structure, and the concave-convex surfaces of the two first cams 2710 are symmetrical.

In some embodiments, the two second gears 2652 are located between the two first gears 2651. The outer diameter and the number of teeth of each second gear 2652 are the same as those of the corresponding first gear 2651. The axis of each first gear 2651 is parallel to the axis of each second gear 2652.In some embodiments, axes of the two first gears 2651 and the two second gears 2652 are coplanar with each other. In some embodiments, the outer diameter of the second gear 2652 is smaller than that of the corresponding first gear 2651. The number of teeth of the second gear 2652 enclosed into a ring or a circle is less than that of the corresponding first gear 2651 enclosed into a ring or a circle. In this way, the overall width of the linkage assembly 26 may be reduced, the overall width of the folding device 22 may be reduced, and the internal space of the housing 20 occupied by folding device 22 may be reduced, thereby facilitating the layout of other components such as the main board, the battery, and so on.

As shown in FIG. 16 and FIG. 17, the first rotating shaft 266 includes a shaft body 2660 and a stopping portion 2662 close to an end of the shaft body 2660. Another end of the shaft body 2660 away from the stopping portion 2662 defines a snapping slot 2663. In some embodiments, the snapping slot 2663 is defined on an outer periphery of the shaft body 2660 and surrounds the periphery of the shaft body 2660 to form a ring. A positioning portion 2665 is arranged at an end of the shaft body 2660 away from the snapping slot 2663. In some embodiments, the stopping portion 2662 is implemented as a stopping ring that is fixedly sleeved on the shaft body 2660. When the first rotating shaft 266 is inserted in the shaft hole 2664 defined in the sleeve 2642, the axis of the first rotating shaft 266 is collinear with an axis of the shaft body 2660. The second rotating shaft 267 includes a shaft body 2670 and a positioning cover 2672 arranged at an end of the shaft body 2670. Another end of the shaft body 2670 away from the positioning cover 2672 defines a snapping slot 2673. The snapping slot 2673 is defined on an outer periphery of the shaft body 2670 and surrounds the periphery of the shaft body 2670 to form a circle. When the second rotating shaft 267 is inserted in the shaft hole 2656 of the sleeve 2653, the axis of the second rotating shaft 267 is collinear with an axis of the shaft body 2670.

The limiting mechanism 27 includes an abutting member 273 and one or more elastic members 274, the abutting member 273 and the one or more elastic members 274 are sleeved on each of the first rotating shafts 266 and the second rotating shafts 267. The one or more elastic members 274 provides an elastic force between the abutting member 273 and the pushing member 271 to enable the abutting member 273 and the pushing member 271 to abut against each other. The rotating assembly 25 rotates with respect to the positioning seat 251 through the limiting mechanism 27. The pushing member 271 is rotatable with respect to the abutting member 273. The one or more elastic members 274 is elastically deformed by being squeezed or pressed by the abutting member 273. The friction resistance between the pushing member 271 and the abutting member 273 enables the linkage member 264 to be maintained at a position or positioned. In this way, the side support member 233 is positioned or maintained at a position with respect to the middle support member 231, one of the two side support members 233 is maintained at an angle from the other of the two side support members 233, and the angle between the two side support members 233 is between 70 degrees and 130 degrees. In some embodiments, when the two side support members 233 of the folding device 22 are synchronously unfolded with each other or synchronously folded with each other through the rotating assembly 25 and the linkage assembly 26 and the angle between the two side support members 233 is greater than or equal to 70 degrees and less than or equal to 130 degrees, the side support members 233 is are maintained at a positions under the friction resistance between the pushing member 271 and the abutting member 273. That is, the two side support members 233 do not rotate with each other in the absence of an external force. It should be noted that, the term "sleeve/sleeved" in some embodiments of the present disclosure means that one component is inserted into another component. For example, the another component defines a through hole, a shaft hole, a groove, etc., and a part of or all of the one component is inserted in the through hole, the shaft hole, or the groove. For example, the linkage member 264 being sleeved on the first rotating shaft 266 means that the linkage member 264 defines the shaft hole 2644, and the first rotating shaft 266 is inserted in the shaft hole 2644. For another example, the abutting member 273 being sleeved on the first rotating shaft 266 and the second rotating shaft 267 means that the abutting member 273 defines shaft holes, and the first rotating shaft 266 and the second rotating shaft 267 are respectively inserted in the shaft holes.

In some embodiments, the limiting mechanism 27 includes two abutting members 273 arranged on two opposite sides of the gear group 265.

In some embodiments, the abutting member 273 includes a second cam 2730. The one or more elastic members 274 elastically pushes and abuts against the abutting member 273, so that the second cam 2730 and the first cam 2710 may rotatably abut against each other. When the first cam 2710 rotates with respect to the second cam 2730, the first cam 2710 rotatably pushes the second cam 2730 to slide away from or close to the gear group 265, the one or more elastic members 274 is squeezed or pressed, and the pushing member 271 may be maintained at an angle from the abutting member 273 under the friction resistance between the first cam 2710 and the second cam 2730. In some embodiments, the abutting member 273 includes a bar-shaped connecting portion 2732 and four second cams 2730 arranged on the connecting portion 2732. The four second cams 2730 are arranged in a lengthwise direction of the connecting portion 2732. In some embodiments, two of the four second cams 2730 are arranged at two opposite ends of the connecting portion 2732, and the other two of the four second cams 2730 are arranged in the middle of the connecting portion 2732. Each of the two second cams 2730 at a corresponding end of the two opposite ends of the connecting portions 2732 is slidably sleeved on the corresponding one of the two rotating shafts 266. Each of the other two of the four second cams 2730 in the middle of the connecting portion 2732 is slidably sleeved on a corresponding one of the two second rotating shafts 267. The second cam 2730 includes a circular sleeve 2773 and a concave-convex surface arranged at an end of the sleeve 2733 facing the gear group 265. A shaft hole 2737 is defined in the sleeve 2733 and penetrates two opposite side surfaces of the connecting portion 2732. The concave-convex surface includes a second convex portion 2734 and a second concave portion 2735. The second convex portion 2734 and the second concave portion 2735 are successively and alternately arranged at intervals in sequence along the peripheral direction of the sleeve 2733. The number of the second convex portions 2734 on the second cam 2730 is equal to the number of the first concave portions 2714 on the first cam 2710. The number of the second concave portions 2735 on the second cam 2730 is equal to the number of the first convex portions 2712 on the first cam 2710. In this way, the first convex portion 2712 may cooperate with the second concave portion 2735, and the second convex portion 2734 may cooperate with the first concave portion 2714. The one or more elastic members 274 includes a first elastic member 2741 sleeved on each of the first rotating shafts 266 and a second elastic member 2743 sleeved on each of the second rotating shafts 2743. The first elastic member 2741 and the second elastic member 2743 may be the same as each other or different from each other. In some embodiments, both the first elastic member 2741 and the second elastic member 2743 are springs.

The limiting mechanism 27 further includes a first positioning member 275, a spacer 277, and a second positioning member 278. The first positioning member 275 is sleeved on the positioning portions 2665 of the two first rotating shafts 266. The spacer 277 is sleeved on both the first rotating shafts 266 and the second rotating shafts 267. The second positioning member 278 is connected to an end of each first rotating shaft 266 away from the first positioning member 275 and an end of the second rotating shaft 267 away from the first positioning member 275. The first positioning member 275 includes a positioning plate 2751 and a connecting plate 2753 connected to the middle of a side of the positioning plate 2751. Each of two opposite ends of the positioning plate 2751 defines a positioning hole 2752. Two opposite end surfaces of the positioning plate 2751 are arc-shaped surfaces. The connecting plate 2753 extends from the middle of the side of the positioning plate 2751 along a direction perpendicular to the positioning plate 2751. An end of the connecting plate 2753 defines a connecting hole 2754. The first elastic member 2741 and the second elastic member 2743 are arranged between the abutting member 273 on one end of the first rotating shaft and the spacer 277. The spacer 277 is a rectangular spacer and defines a plurality of through roles 2771. The plurality of through holes 2771 are arranged along a lengthwise direction of the spacer 277. These through holes 2771 correspond to the two first rotating shafts 266 and the two second rotating shafts 267, respectively. In some embodiments, four through holes 2771 are defined on the spacer 277, and the four through holes 2771 respectively correspond to the two first rotating shafts 266 and the two rotating shafts 267. In some embodiments, two opposite end surfaces of the spacer 277 are arc-shaped surface, to facilitate the folding or unfolding of the folding device 22. A plurality of snapping portions 2782 are arranged on a side of the second positioning member 278. Each snapping portion 2782 may be snapped into the corresponding snapping slot 2663 of the first rotating shaft 266 or the second rotating shaft 267. In some embodiments, the second positioning member 278 is a rectangular positioning sheet, and four snapping portions 2782 are arranged on a side of the positioning sheet. The four snapping portions 2782 are spaced apart from each other along a lengthwise direction of the positioning sheet. In some embodiments, the snapping portions 2782 are U-shaped snaps. The limiting mechanism 27 further includes two positioning sleeves 279, and each positioning sleeve 279 is snapped at the end of a corresponding one of the two first rotating shafts 266 away from the positioning portion 2665.

As shown in FIG. 6 and FIG. 7, the back cover 28 is a strip-shaped frame. The back cover 28 defines a receiving groove 280. The positioning seat 251 and the first positioning member 275 are received in the receiving groove 280 and are fixedly connected to the back cover 28. In some embodiments, the back cover 28 is arranged with three first support columns 281 and three second support columns 285 on the bottom surface of the back cover 28 in the receiving groove 280. The three first support columns 281 are spaced apart from each other along a lengthwise direction of the back cover 28, and the three second support columns 285 are spaced apart from each other along the lengthwise direction of the back cover 28. Each first support column 281 defines a locking hole 2810 along an axial direction thereof. Each second support column 285 defines a locking hole 2850 along an axial direction thereof. The first support columns 281 are configured to be connected to the positioning seat 251. The second support columns 285 are configured to be connected the first positioning member 275. In some embodiments, the positioning seat 251 and the first positioning member 275 may be connected to the back cover 2 by means of, but is not limited to, screwing, snapping, bonding, and so on.

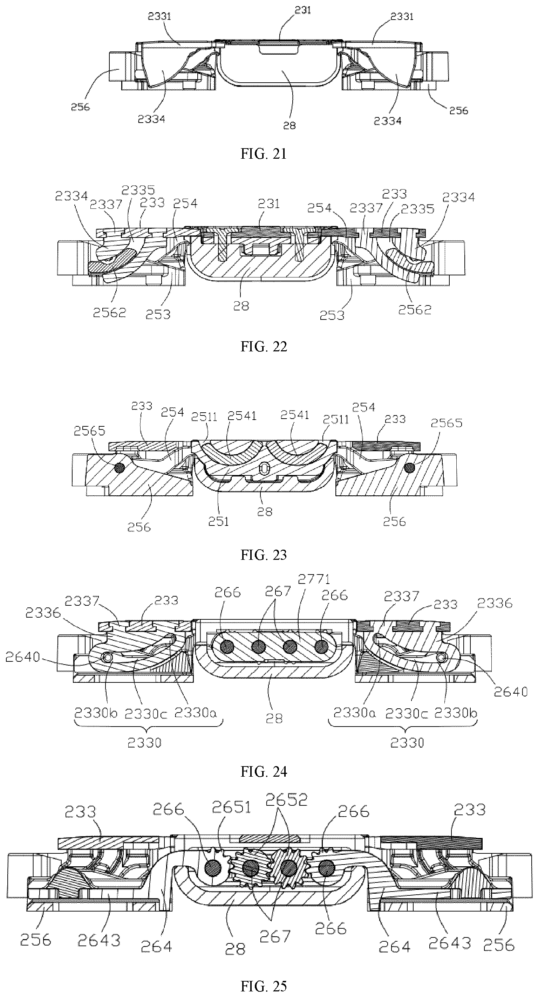

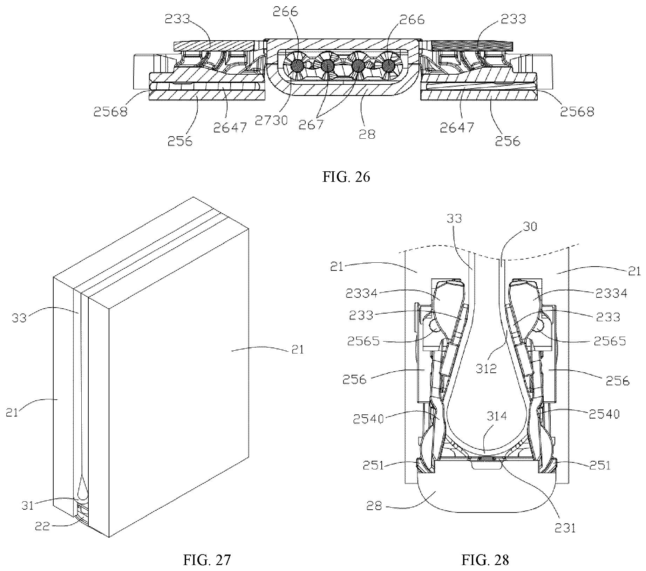

As shown in FIGS. 3 to 26, when assembling the folding device, firstly, the positioning portion 2665 of each of the two first rotating shafts 266 is inserted in the corresponding positioning hole 2752 of the first positioning member 275, until the stopping portion 2662 is stopped at the positioning plate 2751. The spacer 277 is sleeved on the first rotating shafts 266 and the second rotating shafts 267. In some embodiments, the ends of the two first rotating shafts 266 away from the positioning portion 2665 are respectively inserted in the through holes 2771 at the two opposite ends of the spacer 277, and the ends of the two second rotating shafts 267 away from the positioning cover 2672 are respectively inserted in the through holes 2771 in the middle of the spacer 277, until the spacer 277 is stopped at the stopping portion 2662 and the positioning cover 2672. Then, two first elastic members 2741 are respectively sleeved on the two first rotating shafts 266 until one end of each of the first elastic members 2741 abuts against the spacer 277, and the two second elastic members 2743 are respectively sleeved on the two second rotating shafts 267 until one end of each of the second elastic members 2743 abuts against the spacer 277. Next, one of the abutting members 273 is sleeved on the two first rotating shafts 266 and the two second rotating shafts 267. That is, the ends of the two first rotating shafts 266 and the ends of the two second rotating shafts 267 away from the first positioning member 275 are respectively inserted in the four shaft holes 2737 defined in the one abutting member 273 from the side of the abutting member 273 away from the second cam 2730. The two second gears 2652 are engaged with each other. The two linkage members 264 are respectively arranged on the two opposite sides of the two second gears 2652, and the first gear 2651 of each linkage member 264 is engaged with the corresponding second gear 2652. The ends of the two first rotating shafts 266 and the ends of the two second rotating shafts 267 away from positioning member 275 are respectively inserted in the sleeves 2652 of the two linkage members 264 and the shaft holes 2656 defined in the two second gears 2652, enabling the four second cams 2730 of the corresponding abutting member 273 to respectively abut against the first cams 2710 on the two linkage members 264 and the first cams 2710 on the second gears 2652. That is, the first convex portion 2712 of the first cam 2710 is received in the second concave portion 2735 of the corresponding second cam 2730, and the second convex portion 2734 of the second cam 2730 is received in the first concave portion 2714 of the first cam 2710. Then, the other abutting member 273 is sleeved on the two first rotating shafts 266 and the two second rotating shafts 267. That is, the ends of the two first rotating shafts 266 and the ends of the two second rotating shafts 267 away from the first positioning member 275 are respectively inserted in the four shaft holes 2737 of the other abutting member 273 from the side of the other abutting member 273 arranged with the second cam 2730. In this way, the four second cams 2730 arranged on the other abutting member 273 respectively abut against the first cams 2710 on the two linkage members 264 and the first cams 2710 on the second gears 2652. That is, the first convex portion 2712 of the first cam 2710 is received in the second concave portion 2735 of the corresponding second cam 2730, and the second convex portion 2734 of the second cam 2730 is received in the first concave portion 2714 of the first cam 2710. The four snapping portions 2782 of the second positioning members 278 are respectively snapped into the snapping slots 2663 defined in the two first rotating shafts 266 and the snapping slots 2673 defined in the second rotating shafts 267. The two positioning sleeves 279 are respectively fixedly sleeved on the ends of the two first rotating shafts 266 away from the first positioning member 275.

At this time, the sleeves 2642 of the two linkage members 264 are respectively sleeved on the two first rotating shafts 266, and the sleeves 2653 of the two second gears 2652 are respectively sleeved on the two second rotating shafts 267. The two abutting members 273, the one or more elastic members 274, and the spacer 277 are respectively sleeved on the first rotating shafts 266 and the second rotating shafts 267. That is to say, the linkage members 264, the second gears 2652, the abutting members 273, the one or more elastic members 274, and the spacer 277 are all capable of moving along the axial direction of the first rotating shafts 266. The one or more elastic members 274 is arranged between the spacer 277 and one of the abutting members 273. The corresponding abutting member 273 and the spacer 277 are not capable of rotating along with the first rotating shafts 266. One end of the one or more elastic members 274 away from the one abutting member 273 abuts against the spacer 277, and the one or more elastic members 274 is in the state of being squeezed; that is, the one or more elastic members 274 has a pre-elastic force. If the first elastic member 2741 and the second elastic member 2743 are the same, that is, if each of the first elastic member 2741 and the second elastic member 2743 has a pre-elastic force F0, each first cam 2710 may rotatably abut against the corresponding second cam 2730. The axial force F on each of the first cam 2710 and the second cam 2730 on the first rotating shaft 266 is equal to the pre-elastic force F0. That is, F=F0. The axial force F on each of the first cam 2710 and the second cam 2730 of the second rotating shaft 267 is equal to the pre-elastic force F0. That is, F=F0. The axes of the two first rotating shafts 266 are parallel to the axes of the two second rotating shafts 267. That is, the plane formed by the axes of the two first rotating shafts 266 and the plane formed by the axes of the two second rotating shafts 267 are parallel to each other or coplanar with each other. In some embodiments, the axes of the two first rotating shafts 266 and the axes of the two second rotating shafts 267 are coplanar with each other. In some embodiments, the axes of the two second rotating shafts 267 are located on an upper side or a lower side of the plane formed by the axes of the two first rotating shafts 266. The upper side refers to the side which is located closer to the light exit surface of the flexible member 30 than the axes of the two first rotating shafts 266. The lower side refers to the side which is located further away from the light exit surface of the flexible member 30 than the axes of rotation of the two first rotatable axes 266. When the plane formed by the axes of the two second rotating shafts 267 and the plane formed by the axes of the two second rotating shafts 267 are parallel to each other, the relative positions of the first rotating shafts 266 and the second rotating shafts 267 may be more compact, thereby enabling the layout of the various components of the linkage mechanism 26 and the various components of the limiting mechanism 27 more compact, reducing the overall width of the folding device 22, enabling the folding device 22 to occupy less internal space of the folding housing 20, providing space for other electronic components such as the main board, the battery, and so on, and thus the performance of the electronic device 100 is improved.

In some embodiments, the second elastic members 2743 on the two second rotating shafts 267 may be omitted, that is, only the first elastic members 2741 are sleeved on the first rotating shafts 266. Or, the first elastic members 2741 on the two first rotating shafts 266 may be omitted, that is, only the second elastic members 2743 are sleeved on the second rotating shafts 267.

The first rotating blocks 2540 of the two rotating members 254 are respectively connected to the positioning seat 251. In some embodiments, the first rotating blocks 2540 of the two rotating members 254 are arranged between the first seat body 251a and the second seat body 251b, and the two first rotating blocks 2540 are respectively arranged in the receiving space of the second seat body 251b. The first seat body 251a and the second seat body 251b are moved close to each other or approach each other, such that each second arc-shaped rail 2541 of the rotating member 254 may be received in the corresponding second arc-shaped groove 2511. The engaging column 2517 is inserted in the engaging hole 2516. The stopping member 252 is arranged in the positioning recess 2514. Each of the two locking members passes through the corresponding stopping member 252 and is connected to the corresponding connecting hole 2515. In this way, the stopping member 252 is fixed on the first seat body 251a, each of the two stopping portions 2523 respectively extends to an end of the corresponding second arc-shaped groove 2511, so as to prevent the second arc-shaped rail 2541 of the rotating member 254 from being disengaged from the second arc-shaped groove 2511. After the linkage assembly 26 and the limiting mechanism 27 are assembled with each other, the assembled structure formed by the assembled linkage assembly 26 and the limiting mechanism 27 is arranged at the end of the second seat body 251b away from the first seat body 251a. The positioning sleeves 279 of the two first rotating shafts 266 are respectively inserted in the two connecting holes 2518 of the second seat body 251b, and ends of the second rotating shafts 267 adjacent to the second positioning member 278 are respectively inserted in the two shaft holes 2519. Each connecting member 256 is arranged on a corresponding one of two opposite sides of the assembled structure formed by the linkage assembly 26 and the limiting mechanism 27. The connecting rod 2643 of each linkage member 264 is inserted in the sliding-guiding space 2566 of the corresponding connecting member 256. In some embodiments, the sliding-guiding bar 2647 of each connecting rod 2643 is slidably inserted in the corresponding sliding-guiding groove 2568. The second rotating block 2542 of each rotating member 254 is received in the receiving opening 2561 of the corresponding connecting member 256. Each pivot shaft 2565 is then respectively inserted in the corresponding shaft holes 2564 and 2546, so that the end of each rotating member 254 away from the positioning seat 251 is rotatably connected to the corresponding connecting member 256. Then each side support member 233 is arranged on a corresponding one of two opposite sides of the positioning seat 251. The two first arc-shaped rails 2562 of each connecting member 256 are respectively inserted in the two first arc-shaped grooves 2335 on the corresponding side support member 233 in one-to-one correspondence. At the same time, the limiting portion 2336a of the limiting block 2336 of each side support member 233 is inserted in the sliding-guiding opening 2646 of the corresponding linkage member 264. Each sliding-guiding portion 2640 is slidably received in the sliding-limiting groove 2330 of the corresponding limiting block 2336. The sliding-guiding portion 2640 is connected to the corresponding linkage members 264. The rotating assembly 25, the linkage assembly 26, and the limiting mechanism 27 are received in the receiving groove 280 of the back cover 28. The middle support member 231 is arranged on the limiting mechanism 27. A locking member 2525 passes through the connecting hole 2515 defined in the positioning seat 251 and is connected to the locking hole 2810 defined in the corresponding first support column 281. Another locking member passes through the countersunk hole 2313 defined in the middle support member 231 and the connecting hole 2754 defined in the first positioning member 275, and is connected to the locking hole 2850 defined in the second support column 285.

At this time, the axis of rotation between the rotating member 254 and the positioning seat 251 is parallel to the axis of rotation between the side support member 233 and the connecting member 256. The axis of rotation between the rotating member 254 and the positioning seat 251 is parallel to the axis of rotation of the linkage member 264. The axis of rotation between the rotating member 254 and the positioning seat 251 is parallel to the axis of the first rotating shaft 266. When the side support members 233 and the middle support member 231 are in the flattened state, the side support members 233 and the middle support member 231 are arranged side by side. Each first arc-shaped rail 2562 is rotatably inserted in the corresponding first arc-shaped groove 2335. Each second arc-shaped rail 2541 is rotatably received in the corresponding second arc-shaped groove 2511. The sliding-guiding portion 2640 is arranged at the second limiting section 2330b of the sliding-limiting groove 2330. When the side support members 233 are folded with respect to the middle support member 231, the sliding-guiding portion 2640 is located at the first limiting section 2330a of the sliding-guiding groove 2330.

When the connecting member 256 drives the rotating member 254 to rotate with respect to the positioning seat 251, the linkage members 264 rotate around the corresponding first rotating shafts and achieve synchronous rotation through the gear group 265, and the rotating mechanisms 253 drive the side support members 233 to rotate and slide with respect to the positioning seat 251. In this way, the side support members 233 may be folded synchronously with respect to each other or unfolded synchronously with respect to each other. In some embodiments, the rotating member 254 rotates with respect to the positioning seat 251 through the second arc-shaped rail 2541 and the second arc-shaped groove 2511. The linkage member 264 rotates with the rotating mechanism 253 around the corresponding first rotating shaft 266. The linkage member 264 drives the other linkage member 264 to rotate around the corresponding first rotating shaft 266 through the gear group 265. In this way, the two linkage members 264 of the linkage assembly 26 may rotate synchronously with respect to each other. The sliding-guiding bar 2647 of each linkage member 264 slides in the corresponding sliding-guiding groove 2568. Each sliding-guiding portion 2640 slides and rotates in the corresponding sliding-limiting groove 2330. Each first arc-shaped rail 2562 of the connecting member 256 is rotatably connected to the corresponding first arc-shaped groove 2335. Each second arc-shaped rail 2541 of the rotating member 254 is rotatably connected to the corresponding second arc-shaped groove 2511. In this way, each of the two side support members 233 and the middle support member 231 may be folded with respect to each other or unfolded with respect to each other.

When the folding device 22 is folded from the flattened state, one connecting member 256 is folded with respect to the other connecting member 256 with respect to the positioning seat 251. The one connecting member 256 drives the second arc-shaped rail 2541 of the rotating member 254 to rotate in the second arc-shaped groove 2511 of the positioning seat 251. The one connecting member 256 further drives the corresponding linkage member 264 to rotate around the corresponding first rotating shaft 266. The sliding-guiding bar 2647 of the corresponding linkage member 264 slides in the sliding-guiding groove 2568. The sliding-guiding portion 2640 of the linkage member 264 slides from the second limiting section 2330b of the sliding-limiting groove 2330 to the first limiting section 2330a of the sliding-limiting groove 2330. In this way, the corresponding linkage member 264 is driven to rotate around the corresponding first rotating shaft 266. The rotations of the linkage members 264 drive the corresponding first gears 2651 to rotate. The two first gears 2651 are driven to synchronously rotate through the second gears 2652 of the gear group 265. The first gears 2651, which rotate synchronously, drive the two linkage members 264 to approach each other synchronously. At the same time, the connecting member 256 drives the first arc-shaped rail 2562 to be rotatably connected to the corresponding first arc-shaped groove 2335. The rotating member 254 drives the second arc-shaped rail 2541 to be rotatably connected to the corresponding second arc-shaped groove 2511. At the same time, the two linkage members 264 rotate synchronously with respect to each other and approach each other, so as to drive the two side support members 233 to synchronously approach or move towards each other, until the two side support members 233 and the middle support member 231 cooperatively form a structure having a waterdrop-shaped cross section.

In the process of folding the side support member 233 with respect to the middle support member 231, the sliding-guiding portion 2640 slides from the end of the sliding-limiting groove 2330 away from the middle support member 231 (i.e., the second limiting section 2330b of the sliding-limiting groove 2330) to the end of the sliding-limiting groove 2330 close to the middle support member 231 (i.e., the first limiting section 2330a of the sliding-limiting groove 2330). The first cam 2710 abuts against the corresponding second cam 2730, enabling the abutting member 273 to move along the axial direction of the first rotating shafts 266 with respect to the linkage member 264. On each first rotating shaft 266, the axial force between the first cam 2710 and the corresponding second cam 2730 is equal to the elastic force of one elastic member. The friction resistance between the first cam 2710 and the second cam 2730 enables the two side support members 233 to be limited and maintained at a specific angle, and the angle between the two side support members 233 ranges from 70 degrees to 130 degrees.

In some implementations, the two connecting members 256 may rotate synchronously in directions approaching each other. Each connecting member 256 rotates with respect to the other connecting member 256 through the second arc-shaped rail 2541 of the corresponding rotating member 254 and the corresponding second arc-shaped groove 2511 of the positioning seat 251, so as to drive the corresponding linkage member 264 to rotate around the corresponding first rotating shaft 266. At the same time, the two connecting members 256 synchronously drive the first arc-shaped rails 2562 to be rotatably connected to the corresponding first arc-shaped grooves 2335 of the side support members 233, and the sliding-guiding bar 2647 of the corresponding linkage member 264 slides in the sliding-guiding groove 2568. The rotation of the linkage member 264 drives the corresponding first gear 2651 to rotate. The gear group 265 drives two first gears 2651 to rotate synchronously. The first gears 2651, which rotate synchronously, drive the two linkage members 264 to approach each other synchronously around the corresponding first rotating shafts 266. The sliding-guiding portion 2640 of the linkage member 264 slides from the second limiting section 2330b of the sliding-limiting groove 2330 to the first limiting section 2330a of the sliding-limiting groove 2330. At the same time, the two linkage members 264 synchronously rotate around the corresponding first rotating shafts 266 to approach each other, so as to drive the two side support members 233 to synchronously approach each other, until the two side support members 233 and the middle support member 231 cooperatively form a structure having waterdrop-shaped cross sections.

When unfolding the folding device 22 from the fully folded state, one connecting member 256 is unfolded with respect to the positioning seat 251 in a direction away from the other connecting member 256. The one connecting member 256 dives the second arc-shaped rail 2541 of the rotating member 254 to rotate in the second arc-shaped groove 2511 of the positioning seat 251. The one connecting member 256 drives the corresponding linkage member 264 to rotate around the corresponding first rotating shaft 266. The sliding-guiding bar 2647 of the corresponding linkage member 264 slides in the sliding-guiding groove 2568. The sliding-guiding portion 2640 of the linkage member 264 slides from the first limiting section 2330a of the sliding-limiting groove 2330 to the second limiting section 2330b of the sliding-limiting groove 2330. At the same time, the connecting member 256 drives the first arc-shaped rail 2562 to be rotatably connected to the corresponding first arc-shaped groove 2335. The rotation of the linkage member 264 drives the corresponding first gear 2651 to rotate. The second gears 2652 of the gear group 265 drive the two first gears 2651 to rotate synchronously. The first gears 2651, which rotate synchronously, drive the two linkage members 264 to rotate around the corresponding first rotating shafts 266 to synchronously move away from each other. At the same time, the two rotating mechanisms 253 synchronously rotate with respect to the positioning seat 251 to move away from each other, so as to drive the two side support members 233 to be synchronously unfolded with respect to each other, until the two side support members 233 and the middle support member 231 are in the flattened state.

In the process of flattening the side support members 233 with respect to the middle support member 231, the sliding-guiding portion 2640 slides from the end of the sliding-limiting groove 2330 close to the middle support member 231 (i.e., the first limiting section 2330a of the sliding-limiting groove 2330) to the end of the sliding-limiting groove 2330 away from the middle support member 231 (i.e., the second limiting section 2330b of the sliding-limiting groove 2330). The first cam 2710 abuts against the corresponding second cam 2730, enabling the abutting member 273 to move along the axial direction of the first rotating shafts 266 with respect to the linkage member 264. The axial force between the first cam 2710 and the corresponding second cam 2730 on each first rotating shaft 266 and the axial force between the first cam 2710 and the corresponding second cam 2730 on each second rotating shaft 267 are equal to the elastic force of the elastic member. The friction resistance between the first cam 2710 and the second cam 2730 enables the two side support members 233 to be limited and maintained at a specific angle, and the angle between the two side support members 233 ranges from 70 degrees to 130 degrees.

In some implementations, the two connecting members 256 rotates synchronously in directions away from each other. Each connecting member 256 drives the second arc-shaped rail 2541 of the corresponding rotating member 254 to rotate with respect to the second arc-shaped groove 2511 of the positioning seat 251. The connecting member 256 drives the linkage member 264 to rotate around the corresponding first rotating shaft 266, the sliding-guiding bar 2647 of the linkage member 267 slides in the sliding-guiding groove 2568, and the sliding-guiding portion 2640 of the linkage member 264 slides from the first limiting section 2330a of the sliding-limiting groove 2330 to the second limiting section 2330b of the sliding-limiting groove 2330. At the same time, the connecting member 256 drives the first arc-shaped rail 2562 to be rotatably connected to the corresponding first arc-shaped groove 2335. The rotation of the linkage member 264 drives the corresponding first gear 2651 to rotate. The gear group 265 drives two first gears 2651 to rotate synchronously. The first gears 2651, which rotate synchronously, drive the two linkage members 264 to synchronously move away from each other. At the same time, the two rotating mechanisms 253 rotate synchronously with respect to the positioning seat 251 to move away from each other, so as to drive the two side support members 233 to synchronously move away from each other, until the two side support members 233 are flush with the middle support member 231.

As shown in FIGS. 1 to 5, the assembled folding device 22 is arranged between the two frames 21. The connecting member 256 on each of the two opposite sides of the back cover 28 is received in the receiving groove 216 of the corresponding frame 21. Each connecting member 256 is fixedly connected to the corresponding frame 21. At this time, the front surfaces 211 of each frame 21, the front surface of each side support member 233, and the front surface of the middle support member 231 are coplanar with each other. The back surface of the flexible member 30 is connected to the front surface 211 of each frame 21 and the front surface of the folding device 22. In some embodiments, the bendable region 31 is attached to the front surface of the folding device 22, and each of the two non-bendable regions 33 is attached to the front surface of the corresponding frame 21. When the flexible member 30 is in the flattening state, the middle support member 231 is flush with the two side support members 233 are flush, and the folding device 22 is maintained in the flattening state. In addition, the sliding-guiding portion 2640 of the linkage member 264 is slidably received in the sliding-limiting groove 2330 of the corresponding side support member 233. When the folding device 22 is in the folded state, the sliding-guiding portion 2640 is stopped at the first limiting section 2330a of the sliding-limiting groove 2330, so as to prevent the folding device 22 from being further folded and reduce the possibility that the flexible member 30 is damaged. When the folding device 22 is in the flattening state, the sliding-guiding portion 2640 is stopped at the second limiting section 2330b of the sliding-guiding groove 2330 to prevent the folding device 22 from being further unfolded and reduce the possibility that the flexible member 30 is damaged.

As shown in FIGS. 1 to 4 and FIGS. 17 to 28, when the electronic device 100 is folded, a folding force is applied to at least one of the two frames 21 of the electronic device 100, so that the rotating mechanisms 253 connected to the two frames 21 rotate in directions approaching each other. The folding of the folding device 22 may be achieved by the linkage assembly 26. The bendable region 31 of the flexible member 30 is folded and bent along with the support assembly 23. In some embodiments, a folding force is applied to one frame 21, the one frame 21 drives the corresponding rotating member 254 to rotate with respect to the positioning seat 251 towards the side close to the flexible member 30. The second arc-shaped rail 2541 of the rotating member 254 rotates with respect to the second arc-shaped groove 2511 of the positioning seat 251. The connecting member 256 drives the linkage member 264 to rotate around the corresponding first rotating shaft 266, enabling the sliding-guiding bar 2647 of the linkage member 264 to slide in the sliding-guiding groove 2568. The sliding-guiding portion 2640 of the linkage member 264 slides from the second limiting section 2330b of the sliding-limiting groove 2330 to the first limiting section 2330a of the sliding-limiting groove 2330, to drive the corresponding linkage member 264 to rotate around the corresponding first rotating shaft 266. The rotation of the linkage member 264 drives the corresponding first gears 2651 to rotate. The second gears 2652 of the gear group 265 drives the two first gears 2651 to rotate synchronously. The first gears 2651, which rotate synchronously, drive the two linkage members 264 to approach each other synchronously. At the same time, the connecting member 256 drives the first arc-shaped rail 2562 to be rotatably connected to the corresponding first arc-shaped groove 2335. The rotating member 254 drives the second arc-shaped rail 2541 to be rotatably connected to the corresponding second arc-shaped groove 2511. At the same time, the two rotating mechanisms 253 rotate synchronously with respect to the positioning seat 251 and approach each other, so as to drive the two side support members 233 to synchronously approach each other, until the folding device 22 is in the folding state. The bendable region 31 of the flexible member 30 is folded and bent along with the folding device 22, until the front surfaces of the two non-bendable regions 33 of the flexible member 30 are attached to each other. The bendable region is folded into a waterdrop shape; in this way, the seamless folding of the electronic device 100 may be achieved.

In the process of folding the electronic device 100, the first cam 2710 abuts against the corresponding second cam 2730, to enable the abutting member 273 to move along the axis direction of the first rotating shaft 266 with respect to the linkage member 264. The frictional torque force between the first cam 2710 and the second cam 2730 on each first rotating shaft 266 and the frictional torque force between the first cam 2710 and the second cam 2730 on each second rotating shaft 267 resists a rebound force of the flexible member 30, such that the two side support members 233 are relatively positioned at a specific angle, and the angle between the two side support members 233 ranges from 70 degrees to 130 degrees. The bendable region 31 of the flexible member 30 is folded into a waterdrop shape, so as to reduce the space occupied by the folded bendable region 31, thereby reducing the overall thickness of the electronic device 100.

In other ways of folding the electronic device 100, folding forces may be applied to the two frames 21 simultaneously. Each frame 21 drives the corresponding rotating mechanism 253 to rotate towards the flexible member 30, and the electronic device 100 may be folded through the folding device 22.

When it is necessary to flatten the electronic device 100, one frame 21 is pulled outward, so that the two rotating mechanisms 253 connected to the two frames 21 may rotate in directions away from each other. In some embodiments, an outward-pulling force may be applied to one frame 21 of the electronic device 100. The one frame 21 drives the corresponding rotating member 254 to rotate away from the flexible member 30 with respect to the positioning seat 251. The second arc-shaped rail 2541 of the rotating member 254 rotates with respect to the second arc-shaped groove 2511 of the positioning seat 251. The connecting member 256 drives the linkage member 264 to rotate around the corresponding first rotating shaft 266. The sliding-guiding bar 2647 of the linkage member 264 slides in the sliding-guiding groove 2568. The sliding-guiding portion 2640 of the linkage member 264 slides from the first limiting section 2330a of the sliding-limiting groove 2330 to the second limiting section 2330b of the sliding-limiting groove 2330. At the same time, the connecting member 256 drives the first arc-shaped rail 2562 to be rotatably connected to the corresponding first arc-shaped groove 2335. The rotation of the linkage member 264 drives the corresponding first gear 2651 to rotate. The second gears 2652 of the gear group 265 drives the two first gears 2651 to rotate synchronously. The first gears 2651, which rotate synchronously, drive the two linkage members 264 to move away from each other synchronously. At the same time, the two rotating mechanisms 253 rotate synchronously with respect to the positioning seat 251 and move away from each other, so as to drive the two side support members 233 to synchronously move away from each other. In this way, the two side support members 233 may be flattened, the folding device 22 is unfolded, and the bendable region 31 of the flexible member 30 is unfolded along with the folding device 22, until the flexible member 30 is flattened.

In the process of flattening the electronic device 100, the frictional torque force between the first cam 2710 and the second cam 2730 on each first rotating shaft 266 and the frictional torque force between the first cam 2710 and the second cam 2730 on each second rotating shaft 267 resists the rebound force of the flexible member 30. In this way, the two side support members 233 may be relatively positioned at a specific angle, and the angle between the two frames 21 ranges from 70 degrees to 130 degrees.

In other ways of folding the electronic device 100, outward-pulling forces may be applied to the two frames 21 simultaneously. Each frame 21 drives the corresponding rotating mechanism 253 to rotate away from the flexible member 30. The electronic device 100 may be unfolded through the folding device 22.

In the embodiments of the present disclosure, the folding device 22 of the electronic device 100 may be folded or unfolded through the rotating assembly 25 and the linkage assembly 26. When the folding device 22 is in the folded state, the sliding-guiding portion 2640 is stopped at the first limiting section 2330a of the sliding-limiting groove 2330, so as to prevent the folding device 22 from further folded and reduce the possibility that the flexible member 30 is damaged. When the folding device 22 is in the flattened state, the sliding-guiding portion 2640 is stopped at the second limiting section 2330b of the sliding-limiting groove 2330, so as to prevent the folding device 22 from being further unfolded and reduce the possibility that the flexible member 30 is damaged. In addition, since the one or more elastic members 274 of the limiting mechanism 27 may provide a large axial force, the fictional torque force between the first cam 2710 and the second cam 2730 is large enough. Thus, the electronic device 100 may be folded and maintained at a folded angle, and folded angle is between 70 degrees and 130 degrees. Therefore, the hovering function of the whole device may be achieved. In addition, the folding device 22 has a stable structure, and the overall strength of the electronic device 100 may be improved.

## Claims

1. A folding device (22), comprising:
a support assembly (23), comprising a side support member (233) on each of two opposite sides of the folding device (22), wherein the side support member (233) comprises a side support plate (2331) and a plurality of inserts;
a rotating assembly (25), comprising a rotating member (254) on each of two opposite sides of the folding device (22) and a connecting member (256) on each of two opposite sides of the folding device (22), wherein the rotating member (254) is rotatably connected to the connecting member (256), and at least one of the plurality of inserts on the side support member (233) is rotatably connected to the connecting member (256); and
a linkage assembly (26), comprising a linkage member (264) on each of two opposite sides of the folding device (22), wherein the linkage member (264) is slidably connected to the connecting member (256), and at least another one of the plurality of inserts on the side support member (233) is slidably and rotatably connected to the linkage member (264); and
wherein the connecting member (256) is rotatable to drive the rotating member (254) and the linkage member (264) to rotate, and rotations of the rotating member (254) and the linkage member (264) are able to drive the side support member (233) to move, such that the two side support members (233) on the two opposite sides of the folding device (22) are configured to be synchronously folded or synchronously unfolded with respect to each other;
wherein the plurality of inserts of the side support plate (2331) comprise a rotating block (2334) and a limiting block (2336), the rotating block (2334) comprises a rotating portion (2334a) and a support portion (2334b) arranged on the rotating portion (2334a), and the limiting block (2336) comprises a limiting portion (2336a) and a support portion (2336b) arranged on a front surface of the limiting portion (2336);
**characterized in that** each of the plurality of inserts is embedded in a back surface (2333) of the side support plate (2331);
wherein each of the rotating block (2334) and the limiting block (2336) comprises a connecting portion (2337), the connecting portion (2337) protrudes from a side of the support portion (2334b) away from the rotating portion (2334a) or a side of the support portion (2336b) away from the limiting portion (2336a), and the connecting portion (2337) is embedded in the side support plate (2331).

2. The folding device (22) as claimed in claim 1, wherein the side support plate (2331) and the plurality of inserts are integrally moulded.

3. The folding device (22) as claimed in claim 2, wherein the side support plate (2331) is made of a plastic material, the plurality of inserts and the side support plate (2331) are made of different materials, and the hardness of each of the plurality of inserts is greater than or equal to that of the side support plate (2331).

4. The folding device (22) as claimed in claim 3, wherein the connecting portion (2337) defines one or more positioning recesses (2337a), and the side support plate (2331) comprises one or more flanges (2331a) facing the one or more positioning recesses (2337a); or
the connecting portion (2337) comprises one or more flanges (2331a), and the side support plate (2331) defines one or more positioning recesses (2337a) facing the one or more flanges (2331a).

5. The folding device (22) as claimed in claim 4, wherein the one or more flanges (2331a) are continuously or intermittently arranged on a plane substantially parallel to the back surface of the side support plate (2331), and the one or more positioning recesses (2337a) are continuously or intermittently arranged on a plane substantially parallel to the back surface of the side support plate (2331).

6. The folding device (22) as claimed in any one of claims 1 to 5, wherein the rotating block (2334) and the limiting block (2336) are embedded in the side support plate (2331), the rotating block (2334) is rotatably connected to the connecting member (256), and the limiting block (2336) is mated with the linkage member (264) through an engagement between a sliding-limiting groove (2330) and a sliding-guiding portion (2640).

7. The folding device (22) as claimed in claim 6, wherein the limiting block (2336) defines the sliding-limiting groove (2330), and the sliding-guiding portion (2640) is arranged in the linkage member (264); or the sliding-guiding portion (2640) is arranged in the limiting block (2336), and the linkage member (264) defines the sliding-limiting groove (2330);
the sliding-limiting groove (2330) extends obliquely in a direction away from the side support plate (2331); wherein the sliding-limiting groove (2330) comprises a first limiting section (2330a) and a second limiting section (2330b), the first limiting section (2330a) and the second limiting section (2330b) are located at opposite ends of the sliding-limiting groove (2330), and the second limiting section (2330b) is disposed farther away from the side support plate (2331) than the first limiting section (2330a); and
in response to the two side support members (233) being in a fully folded state, the sliding-guiding portion (2640) is positioned at the first limiting section (2330a); and in response to the two side support members (233) being in a flattened state, the sliding-guiding portion (2640) is positioned at the second limiting section (2330b).

8. The folding device (22) as claimed in claim 6, further comprising a limiting assembly, wherein the limiting assembly comprises a pushing member (271) arranged on the linkage member (264), an abutting member (273), and an elastic member (274), the elastic member (274) is configured to provide a pre-elastic force that enables the abutting member (273) and the pushing member (271) to abut against each other; and
wherein the pushing member (271) comprises a first cam (2710), the abutting member (273) comprises a second cam (2730), the elastic member (274) is configured to elastically push against the abutting member (273) to enable the first cam (2710) and the second cam (2730) to rotatably abut against each other, the pushing member (271) is rotatable with respect to the abutting member (273), the elastic member (274) is elastically deformed by being squeezed by the abutting member (273), and the linkage member (264) is maintained at a position by a friction resistance between the pushing member (271) and the abutting member (273).

9. The folding device (22) as claimed in claim 1, wherein the support assembly (23) comprises a middle support member (231), the rotating assembly (25) comprises a positioning seat (251), the rotating member (254) and the connecting member (256) is disposed on each of two opposite sides of the positioning seat (251), an end of the rotating member (254) away from the connecting member (256) is rotatably connected to the positioning seat (251), a side of the side support member (233) away from the middle support member (231) is rotatably connected to the connecting member (256), and the linkage assembly (26) is connected between the positioning seat (251) and the two connecting members (256) arranged on two opposite sides of the positioning seat (251).

10. The folding device (22) as claimed in claim 9, wherein the side support member (233) and the connecting member (256) are rotatably connected to each other through a cooperation between a first arc-shaped groove (2335) and a first arc-shaped rail (2562), and the positioning seat (251) and the rotating member (254) are rotatably connected to each other through a cooperation between a second arc-shaped groove (2511) and a second arc-shaped rail (2541).

11. The folding device (22) as claimed in claim 10, wherein the first arc-shaped rail (2562) at each end of the connecting member (256) is rotatably inserted in the first arc-shaped groove (2335) of the side support member (233), the connecting member (256) and the side support member (233) are rotatable with respect to each other along the first arc-shaped groove (2335), an axis of the first arc-shaped rail (2562) is collinear with an axis of the first arc-shaped groove (2335), and the axis of the first arc-shaped rail (2562) is collinear with the axis of rotation between the side support member (233) and the connecting member (256).

12. The folding device (22) as claimed in claim 11, wherein the rotating member (254) is arranged with the second arc-shaped rail (2541) facing the second arc-shaped groove (2511), the rotating member (254) and the positioning seat (251) are rotatable with respect to each other along the second arc-shaped groove (2511), an axis of the second arc-shaped groove (2511) is collinear with an axis of the second arc-shaped rail (2541), and the axis of the second arc-shaped rail (2541) is collinear with the axis of rotation between the rotating member (254) and the positioning seat (251).

13. The folding device (22) as claimed in claim 9, wherein the positioning seat (251) comprises a first seat body (251a) and a second seat body (251b) connected to the first seat body (251a); an end of the rotating member (254) away from the connecting member (256) is rotatably connected between the first seat body (251a) and the second seat body (251b).

14. A folding housing (20), **characterized by** comprising:
two frames (21); and
the folding device (22) as claimed in any one of claims 1-13, wherein the the folding device (22) is arranged between the two frames (21)
wherein each of the two frames (21) is connected to the connecting member (256) on a corresponding one of the two opposite sides of the folding device (22).

15. An electronic device (100), **characterized by** comprising:
the folding housing (20) as claimed in claim 14, and
a flexible member (30), arranged on the folding housing (20).

## Patentansprüche

1. Faltvorrichtung (22), umfassend:
eine Stützbaugruppe (23), die ein seitliches Stützelement (233) auf jeder der zwei gegenüberliegenden Seiten der Faltvorrichtung (22) umfasst, wobei das seitliche Stützelement (233) eine seitliche Stützplatte (2331) und eine Mehrzahl von Einlegeteilen umfasst;
eine Drehanordnung (25), die ein Drehelement (254) auf jeder der zwei gegenüberliegenden Seiten der Faltvorrichtung (22) und ein Verbindungselement (256) auf jeder der zwei gegenüberliegenden Seiten der Faltvorrichtung (22) umfasst, wobei das Drehelement (254) drehbar mit dem Verbindungselement (256) verbunden ist und mindestens eines der Mehrzahl von Einlegeteilen an dem seitlichen Stützelement (233) drehbar mit dem Verbindungselement (256) verbunden ist; und
eine Gestängebaugruppe (26), die ein Gestängeelement (264) auf jeder der zwei gegenüberliegenden Seiten der Faltvorrichtung (22) umfasst, wobei das Gestängeelement (264) verschiebbar mit dem Verbindungselement (256) verbunden ist und mindestens ein weiteres der Mehrzahl von Einlegeteilen an dem seitlichen Stützelement (233) verschiebbar und drehbar mit dem Gestängeelement (264) verbunden ist; und
wobei das Verbindungselement (256) drehbar ist, um das Drehelement (254) und das Gestängeelement (264) zum Drehen anzutreiben, und Drehungen des Drehelements (254) und
des Gestängeelements (264) in der Lage sind, das seitliche Stützelement (233) zum Bewegen anzutreiben, sodass die zwei seitlichen Stützelemente (233) auf den zwei gegenüberliegenden Seiten der Faltvorrichtung (22) dazu ausgebildet sind, synchron gefaltet oder synchron entfaltet zu werden;
wobei die Mehrzahl von Einlegeteilen der seitlichen Stützplatte (2331) einen Drehblock (2334) und einen Begrenzungsblock (2336) umfasst, der Drehblock (2334) einen Drehabschnitt (2334a) und einen auf dem Drehabschnitt (2334a) angeordneten Stützabschnitt (2334b) umfasst, und der Begrenzungsblock (2336) einen Begrenzungsabschnitt (2336a) und einen auf einer Vorderfläche des Begrenzungsabschnitts (2336) angeordneten Stützabschnitt (2336b) umfasst;
**dadurch gekennzeichnet, dass** jedes der Mehrzahl von Einlegeteilen in eine Rückfläche (2333) der seitlichen Stützplatte (2331) eingebettet ist;
wobei jeder von dem Drehblock (2334) und dem Begrenzungsblock (2336) einen Verbindungsabschnitt (2337) umfasst, der Verbindungsabschnitt (2337) von einer Seite des Stützabschnitts (2334b) weg vom Drehabschnitt (2334a) oder von einer Seite des Stützabschnitts (2336b) weg vom Begrenzungsabschnitt (2336a) hervorsteht, und der Verbindungsabschnitt (2337) in die seitliche Stützplatte (2331) eingebettet ist.

2. Faltvorrichtung (22) nach Anspruch 1, wobei die seitliche Stützplatte (2331) und die Mehrzahl von Einlegeteilen einstückig geformt sind.

3. Faltvorrichtung (22) nach Anspruch 2, wobei die seitliche Stützplatte (2331) aus einem Kunststoffmaterial hergestellt ist, die Mehrzahl von Einlegeteilen und die seitliche Stützplatte (2331) aus unterschiedlichen Materialien hergestellt sind und die Härte jedes der Mehrzahl von Einlegeteilen größer als oder gleich der Härte der seitlichen Stützplatte (2331) ist.

4. Faltvorrichtung (22) nach Anspruch 3, wobei der Verbindungsabschnitt (2337) eine oder mehrere Positionierungsausnehmungen (2337a) definiert und die seitliche Stützplatte (2331) einen oder mehrere Flansche (2331a) umfasst, die der einen oder den mehreren Positionierungsausnehmungen (2337a) zugewandt sind; oder
der Verbindungsabschnitt (2337) einen oder mehrere Flansche (2331a) umfasst und die seitliche Stützplatte (2331) eine oder mehrere Positionierungsausnehmungen (2337a) definiert, die dem einen oder den mehreren Flanschen (2331a) zugewandt sind.

5. Faltvorrichtung (22) nach Anspruch 4, wobei der eine oder die mehreren Flansche (2331a) kontinuierlich oder intermittierend auf einer Ebene angeordnet sind, die im Wesentlichen parallel zur Rückfläche der seitlichen Stützplatte (2331) ist, und die eine oder die mehreren Positionierungsausnehmungen (2337a) kontinuierlich oder intermittierend auf einer Ebene angeordnet sind, die im Wesentlichen parallel zur Rückfläche der seitlichen Stützplatte (2331) ist.

6. Faltvorrichtung (22) nach einem der Ansprüche 1 bis 5, wobei der Drehblock (2334) und der Begrenzungsblock (2336) in die seitliche Stützplatte (2331) eingebettet sind, der Drehblock (2334) drehbar mit dem Verbindungselement (256) verbunden ist und der Begrenzungsblock (2336) über einen Eingriff zwischen einer Gleitbegrenzungsnut (2330) und einem Gleitführungsabschnitt (2640) mit dem Gestängeelement (264) gepaart ist.

7. Faltvorrichtung (22) nach Anspruch 6, wobei der Begrenzungsblock (2336) die Gleitbegrenzungsnut (2330) definiert und der Gleitführungsabschnitt (2640) in dem Gestängeelement (264) angeordnet ist; oder
der Gleitführungsabschnitt (2640) in dem Begrenzungsblock (2336) angeordnet ist und das Gestängeelement (264) die Gleitbegrenzungsnut (2330) definiert;
die Gleitbegrenzungsnut (2330) sich schräg in einer Richtung weg von der seitlichen Stützplatte (2331) erstreckt; wobei die Gleitbegrenzungsnut (2330) einen ersten Begrenzungsabschnitt (2330a) und einen zweiten Begrenzungsabschnitt (2330b) umfasst, der erste Begrenzungsabschnitt (2330a) und der zweite Begrenzungsabschnitt (2330b) an entgegengesetzten Enden der Gleitbegrenzungsnut (2330) angeordnet sind und der zweite Begrenzungsabschnitt (2330b) weiter von der seitlichen Stützplatte (2331) entfernt angeordnet ist als der erste Begrenzungsabschnitt (2330a); und
wenn sich die zwei seitlichen Stützelemente (233) in einem vollständig gefalteten Zustand befinden, ist der Gleitführungsabschnitt (2640) am ersten Begrenzungsabschnitt (2330a) positioniert; und wenn sich die zwei seitlichen Stützelemente (233) in einem abgeflachten Zustand befinden, ist der Gleitführungsabschnitt (2640) am zweiten Begrenzungsabschnitt (2330b) positioniert.

8. Faltvorrichtung (22) nach Anspruch 6, ferner umfassend eine Begrenzungsbaugruppe, wobei die Begrenzungsbaugruppe ein an dem Gestängeelement (264) angeordnetes Schubelement (271), ein Anschlagelement (273) und ein elastisches Element (274) umfasst, wobei das elastische Element (274) dazu ausgebildet ist, eine Vorelastikkraft bereitzustellen, die es dem Anschlagelement (273) und dem Schubelement (271) ermöglicht, gegeneinander anzuschlagen; und
wobei das Schubelement (271) eine erste Nocke (2710) umfasst, das Anschlagelement (273) eine zweite Nocke (2730) umfasst, das elastische Element (274) dazu ausgebildet ist, elastisch gegen das Anschlagelement (273) zu drücken, um der ersten Nocke (2710) und der zweiten Nocke (2730) zu ermöglichen, drehend gegeneinander anzuschlagen, das Schubelement (271) relativ zum Anschlagelement (273) drehbar ist, das elastische Element (274) durch Zusammendrücken durch das Anschlagelement (273) elastisch verformt wird und das Gestängeelement (264) durch einen Reibungswiderstand zwischen dem Schubelement (271) und dem Anschlagelement (273) in einer Position gehalten wird.

9. Faltvorrichtung (22) nach Anspruch 1, wobei die Stützbaugruppe (23) ein mittleres Stützelement (231) umfasst, die Drehanordnung (25) einen Positioniersitz (251) umfasst, das Drehelement (254) und das Verbindungselement (256) auf jeder der zwei gegenüberliegenden Seiten des Positioniersitzes (251) angeordnet sind, ein Ende des Drehelements (254) weg vom Verbindungselement (256) drehbar mit dem Positioniersitz (251) verbunden ist, eine Seite des seitlichen Stützelements (233) weg vom mittleren Stützelement (231) drehbar mit dem Verbindungselement (256) verbunden ist, und die Gestängebaugruppe (26) zwischen dem Positioniersitz (251) und den zwei Verbindungselementen (256) verbunden ist, die auf zwei gegenüberliegenden Seiten des Positioniersitzes (251) angeordnet sind.

10. Faltvorrichtung (22) nach Anspruch 9, wobei das seitliche Stützelement (233) und das Verbindungselement (256) über eine Zusammenwirkung zwischen einer ersten bogenförmigen Nut (2335) und einer ersten bogenförmigen Schiene (2562) drehbar miteinander verbunden sind, und der Positioniersitz (251) und das Drehelement (254) über eine Zusammenwirkung zwischen einer zweiten bogenförmigen Nut (2511) und einer zweiten bogenförmigen Schiene (2541) drehbar miteinander verbunden sind.

11. Faltvorrichtung (22) nach Anspruch 10, wobei die erste bogenförmige Schiene (2562) an jedem Ende des Verbindungselements (256) drehbar in die erste bogenförmige Nut (2335) des seitlichen Stützelements (233) eingesetzt ist, das Verbindungselement (256) und das seitliche Stützelement (233) entlang der ersten bogenförmigen Nut (2335) relativ zueinander drehbar sind, eine Achse der ersten bogenförmigen Schiene (2562) mit einer Achse der ersten bogenförmigen Nut (2335) kollinear ist und die Achse der ersten bogenförmigen Schiene (2562) mit der Drehachse zwischen dem seitlichen Stützelement (233) und dem Verbindungselement (256) kollinear ist.

12. Faltvorrichtung (22) nach Anspruch 11, wobei das Drehelement (254) mit der zweiten bogenförmigen Schiene (2541) angeordnet ist, die der zweiten bogenförmigen Nut (2511) zugewandt ist, das Drehelement (254) und der Positioniersitz (251) entlang der zweiten bogenförmigen Nut (2511) relativ zueinander drehbar sind, eine Achse der zweiten bogenförmigen Nut (2511) mit einer Achse der zweiten bogenförmigen Schiene (2541) kollinear ist und die Achse der zweiten bogenförmigen Schiene (2541) mit der Drehachse zwischen dem Drehelement (254) und dem Positioniersitz (251) kollinear ist.

13. Faltvorrichtung (22) nach Anspruch 9, wobei der Positioniersitz (251) einen ersten Sitzkörper (251a) und einen mit dem ersten Sitzkörper (251a) verbundenen zweiten Sitzkörper (251b) umfasst; ein Ende des Drehelements (254) weg vom Verbindungselement (256) drehbar zwischen dem ersten Sitzkörper (251a) und dem zweiten Sitzkörper (251b) verbunden ist.

14. Faltgehäuse (20), **dadurch gekennzeichnet, dass** es umfasst:
zwei Rahmen (21); und
die Faltvorrichtung (22) nach einem der Ansprüche 1 bis 13, wobei die Faltvorrichtung (22) zwischen den zwei Rahmen (21) angeordnet ist
wobei jeder der zwei Rahmen (21) mit dem Verbindungselement (256) auf einer entsprechenden der zwei gegenüberliegenden Seiten der Faltvorrichtung (22) verbunden ist.

15. Elektronisches Gerät (100), **dadurch gekennzeichnet, dass** es umfasst:
das Faltgehäuse (20) nach Anspruch 14, und
ein flexibles Element (30), das auf dem Faltgehäuse (20) angeordnet ist.

## Revendications

1. Dispositif de pliage (22), comprenant :
un ensemble de support (23), comprenant un élément de support latéral (233) sur chacun des deux côtés opposés du dispositif de pliage (22), l'élément de support latéral (233) comprenant une plaque de support latéral (2331) et une pluralité d'inserts ;
un ensemble rotatif (25), comprenant un élément rotatif (254) sur chacun des deux côtés opposés du dispositif de pliage (22) et un élément de connexion (256) sur chacun des deux côtés opposés du dispositif de pliage (22), l'élément rotatif (254) étant raccordé en rotation à l'élément de connexion (256), et au moins l'un de la pluralité d'inserts sur l'élément de support latéral (233) étant raccordé en rotation à l'élément de connexion (256) ; et
un ensemble de tringlerie (26), comprenant un élément de tringlerie (264) sur chacun des deux côtés opposés du dispositif de pliage (22), l'élément de tringlerie (264) étant raccordé en coulissement à l'élément de connexion (256), et au moins un autre de la pluralité d'inserts sur l'élément de support latéral (233) étant raccordé en coulissement et en rotation à l'élément de tringlerie (264) ; et
dans lequel l'élément de connexion (256) peut pivoter pour entraîner l'élément rotatif (254) et l'élément de tringlerie (264) à pivoter, et les rotations de l'élément rotatif (254) et de l'élément de tringlerie (264) sont aptes à entraîner l'élément de support latéral (233) à se déplacer, de telle sorte que les deux éléments de support latéral (233) sur les deux côtés opposés du dispositif de pliage (22) sont configurés pour être pliés de manière synchrone ou dépliés de manière synchrone l'un par rapport à l'autre ;
dans lequel la pluralité d'inserts de la plaque de support latéral (2331) comprend un bloc rotatif (2334) et un bloc de limitation (2336), le bloc rotatif (2334) comprend une partie rotative (2334a) et une partie de support (2334b) disposée sur la partie rotative (2334a), et le bloc de limitation (2336) comprend une partie de limitation (2336a) et une partie de support (2336b) disposée sur une surface avant de la partie de limitation (2336) ;
**caractérisé en ce que** chacun de la pluralité d'inserts est noyé dans une surface arrière (2333) de la plaque de support latéral (2331) ;
dans lequel chacun parmi le bloc rotatif (2334) et le bloc de limitation (2336) comprend une partie de connexion (2337), la partie de connexion (2337) fait saillie depuis un côté de la partie de support (2334b) opposé à la partie rotative (2334a) ou depuis un côté de la partie de support (2336b) opposé à la partie de limitation (2336a), et la partie de connexion (2337) est noyée dans la plaque de support latéral (2331).

2. Dispositif de pliage (22) selon la revendication 1, dans lequel la plaque de support latéral (2331) et la pluralité d'inserts sont moulés d'un seul tenant.

3. Dispositif de pliage (22) selon la revendication 2, dans lequel la plaque de support latéral (2331) est réalisée en matériau plastique, la pluralité d'inserts et la plaque de support latéral (2331) sont réalisés en des matériaux différents, et la dureté de chacun de la pluralité d'inserts est supérieure ou égale à celle de la plaque de support latéral (2331).

4. Dispositif de pliage (22) selon la revendication 3, dans lequel la partie de connexion (2337) définit un ou plusieurs évidements de positionnement (2337a), et la plaque de support latéral (2331) comprend une ou plusieurs brides (2331a) faisant face au ou aux évidements de positionnement (2337a) ; ou
la partie de connexion (2337) comprend une ou plusieurs brides (2331a), et la plaque de support latéral (2331) définit un ou plusieurs évidements de positionnement (2337a) faisant face à la ou aux brides (2331a).

5. Dispositif de pliage (22) selon la revendication 4, dans lequel la ou les brides (2331a) sont disposées de manière continue ou intermittente sur un plan sensiblement parallèle à la surface arrière de la plaque de support latéral (2331), et le ou les évidements de positionnement (2337a) sont disposés de manière continue ou intermittente sur un plan sensiblement parallèle à la surface arrière de la plaque de support latéral (2331).

6. Dispositif de pliage (22) selon l'une quelconque des revendications 1 à 5, dans lequel le bloc rotatif (2334) et le bloc de limitation (2336) sont noyés dans la plaque de support latéral (2331), le bloc rotatif (2334) est raccordé en rotation à l'élément de connexion (256), et le bloc de limitation (2336) est accouplé à l'élément de tringlerie (264) par l'intermédiaire d'un engagement entre une rainure de guidage-limitation coulissante (2330) et une partie de guidage coulissante (2640).

7. Dispositif de pliage (22) selon la revendication 6, dans lequel le bloc de limitation (2336) définit la rainure de guidage-limitation coulissante (2330), et la partie de guidage coulissante (2640) est disposée dans l'élément de tringlerie (264) ; ou
la partie de guidage coulissante (2640) est disposée dans le bloc de limitation (2336), et l'élément de tringlerie (264) définit la rainure de guidage-limitation coulissante (2330) ;
la rainure de guidage-limitation coulissante (2330) s'étend en oblique dans une direction s'éloignant de la plaque de support latéral (2331) ; dans lequel la rainure de guidage-limitation coulissante (2330) comprend une première section de limitation (2330a) et une deuxième section de limitation (2330b), la première section de limitation (2330a) et la deuxième section de limitation (2330b) sont situées aux extrémités opposées de la rainure de guidage-limitation coulissante (2330), et la deuxième section de limitation (2330b) est disposée plus loin de la plaque de support latéral (2331) que la première section de limitation (2330a) ; et
en réponse aux deux éléments de support latéral (233) se trouvant dans un état entièrement plié, la partie de guidage coulissante (2640) est positionnée au niveau de la première section de limitation (2330a) ; et en réponse aux deux éléments de support latéral (233) se trouvant dans un état aplati, la partie de guidage coulissante (2640) est positionnée au niveau de la deuxième section de limitation (2330b).

8. Dispositif de pliage (22) selon la revendication 6, comprenant en outre un ensemble de limitation, dans lequel l'ensemble de limitation comprend un élément de poussée (271) disposé sur l'élément de tringlerie (264), un élément de butée (273), et un élément élastique (274), l'élément élastique (274) est configuré pour fournir une force pré-élastique permettant à l'élément de butée (273) et à l'élément de poussée (271) de venir en butée l'un contre l'autre ; et dans lequel l'élément de poussée (271) comprend une première came (2710), l'élément de butée (273) comprend une deuxième came (2730), l'élément élastique (274) est configuré pour pousser élastiquement contre l'élément de butée (273) afin de permettre à la première came (2710) et à la deuxième came (2730) de venir en butée en rotation l'une contre l'autre, l'élément de poussée (271) peut pivoter par rapport à l'élément de butée (273), l'élément élastique (274) est déformé élastiquement en étant comprimé par l'élément de butée (273), et l'élément de tringlerie (264) est maintenu dans une position par une résistance au frottement entre l'élément de poussée (271) et l'élément de butée (273).

9. Dispositif de pliage (22) selon la revendication 1, dans lequel l'ensemble de support (23) comprend un élément de support central (231), l'ensemble rotatif (25) comprend un siège de positionnement (251), l'élément rotatif (254) et l'élément de connexion (256) sont disposés sur chacun des deux côtés opposés du siège de positionnement (251), une extrémité de l'élément rotatif (254) opposée à l'élément de connexion (256) est raccordée en rotation au siège de positionnement (251), un côté de l'élément de support latéral (233) opposé à l'élément de support central (231) est raccordé en rotation à l'élément de connexion (256), et l'ensemble de tringlerie (26) est raccordé entre le siège de positionnement (251) et les deux éléments de connexion (256) disposés sur les deux côtés opposés du siège de positionnement (251).

10. Dispositif de pliage (22) selon la revendication 9, dans lequel l'élément de support latéral (233) et l'élément de connexion (256) sont raccordés en rotation l'un à l'autre par une coopération entre une première rainure en arc de cercle (2335) et un premier rail en arc de cercle (2562), et le siège de positionnement (251) et l'élément rotatif (254) sont raccordés en rotation l'un à l'autre par une coopération entre une deuxième rainure en arc de cercle (2511) et un deuxième rail en arc de cercle (2541).

11. Dispositif de pliage (22) selon la revendication 10, dans lequel le premier rail en arc de cercle (2562) à chaque extrémité de l'élément de connexion (256) est inséré en rotation dans la première rainure en arc de cercle (2335) de l'élément de support latéral (233), l'élément de connexion (256) et l'élément de support latéral (233) peuvent pivoter l'un par rapport à l'autre le long de la première rainure en arc de cercle (2335), un axe du premier rail en arc de cercle (2562) est colinéaire avec un axe de la première rainure en arc de cercle (2335), et l'axe du premier rail en arc de cercle (2562) est colinéaire avec l'axe de rotation entre l'élément de support latéral (233) et l'élément de connexion (256).

12. Dispositif de pliage (22) selon la revendication 11, dans lequel l'élément rotatif (254) est disposé avec le deuxième rail en arc de cercle (2541) faisant face à la deuxième rainure en arc de cercle (2511), l'élément rotatif (254) et le siège de positionnement (251) peuvent pivoter l'un par rapport à l'autre le long de la deuxième rainure en arc de cercle (2511), un axe de la deuxième rainure en arc de cercle (2511) est colinéaire avec un axe du deuxième rail en arc de cercle (2541), et l'axe du deuxième rail en arc de cercle (2541) est colinéaire avec l'axe de rotation entre l'élément rotatif (254) et le siège de positionnement (251).

13. Dispositif de pliage (22) selon la revendication 9, dans lequel le siège de positionnement (251) comprend un premier corps de siège (251a) et un deuxième corps de siège (251b) raccordé au premier corps de siège (251a) ; une extrémité de l'élément rotatif (254) opposée à l'élément de connexion (256) est raccordée en rotation entre le premier corps de siège (251a) et le deuxième corps de siège (251b).

14. Boîtier de pliage (20), **caractérisé en ce qu'**il comprend :
deux châssis (21) ; et
le dispositif de pliage (22) selon l'une quelconque des revendications 1 à 13, dans lequel le dispositif de pliage (22) est disposé entre les deux châssis (21)
dans lequel chacun des deux châssis (21) est raccordé à l'élément de connexion (256) sur l'un correspondant des deux côtés opposés du dispositif de pliage (22).

15. Dispositif électronique (100), **caractérisé en ce qu'**il comprend :
le boîtier de pliage (20) selon la revendication 14, et
un élément flexible (30), disposé sur le boîtier de pliage (20).
